# EUROPÄISCHE PATENTSCHRIFT

(11) **EP 3 186 680 B1**
(45) Veröffentlichungstag und Bekanntmachung des Hinweises auf die Patenterteilung: **10.06.2020**
(21) Anmeldenummer: 15756156.4
(22) Anmeldetag: 27.08.2015
(51) Int. Cl.: G03F 7/20

(54) **VORRICHTUNG UND VERFAHREN ZUR HERSTELLUNG VON FLEXODRUCKPLATTEN**
APPARATUS AND METHOD FOR PRODUCING FLEXOGRAPHIC PRINTING PLATES
DISPOSITIF ET PROCÉDÉ POUR LA PRODUCTION DE PLAQUES POUR L'IMPRESSION FLEXOGRAPHIQUE

(30) Priorität: 28.08.2014 EP 14182579
(43) Veröffentlichungstag der Anmeldung: 05.07.2017
(73) Patentinhaber: Flint Group Germany GmbH, 70469 Stuttgart (DE)
(72) Erfinder: DIETZ, Gernot, 67304 Eisenberg (DE); MÜHLFEIT, Markus, 71263 Weil der Stadt (DE); BOYKSEN, Frank, 71155 Altdorf (DE)
(74) Vertreter: Schuck, Alexander
(86) Internationale Anmeldenummer: PCT/EP2015/069616
(87) Internationale Veröffentlichungsnummer: WO 2016/030450

(56) Entgegenhaltungen:
- EP-A1- 0 819 989
- WO-A1-2015/007667
- WO-A1-2015/044437
- DE-A1-102010 031 527
- US-A- 5 262 275
- US-A1- 2013 209 939

## Beschreibung

Die vorliegende Erfindung betrifft eine Vorrichtung zur Herstellung von Flexodruckplatten ausgehend von digital bebilderbaren Flexodruckelementen, mit der sich mindestens die Verfahrensschritte Rückseitenbelichtung, Hauptbelichtung, Entwickeln mittels Auswaschmitteln, Trocknen und Nachbehandeln automatisiert durchführen lassen, wobei die Vorrichtung mindestens zwei verschiedene Transportvorrichtungen umfasst, mit denen die Flexodruckelemente bzw. -platten durch die Vorrichtung transportiert werden. Die Erfindung betrifft weiterhin ein Verfahren zur Herstellung von Flexodruckplatten unter Verwendung der besagten Vorrichtung.

Digital bebilderbare Flexodruckelemente sind prinzipiell bekannt. Sie umfassen mindestens einen dimensionsstabilen Träger, eine fotopolymerisierbare Schicht sowie eine digital bebilderbare Schicht. Bei der digital bebilderbaren Schicht kann es sich beispielsweise um eine laserablatierbare Schicht, um eine mittels Ink-Jet-Drucker beschreibbare Schicht oder um eine thermographische Schicht handeln, wobei laserablatierbare Schichten, auch LAMS (laserablatierbare Maskenschichten) genannt, am gebräuchlichsten sind.

Die Herstellung von Flexodruckformen ausgehend von fotopolymerisierbaren, digital bebilderbaren Flexodruckelementen erfolgt mittels eines mehrstufigen Prozesses unter Verwendung entsprechender Vorrichtungen für jeden Verfahrensschritt.

Zunächst wird eine Maske in die digital bebilderbare Schicht unter Verwendung eines IR-Lasers eingeschrieben. Es kann sich hierbei um Laserapparaturen mit rotierender Trommel, Flachbettapparaturen oder Innentrommellaser handeln.

Nach dem Einschreiben der Maske wird das Flexodruckelement durch die gebildete Maske hindurch mit UV-Strahlung bzw. UV/VIS-Strahlung belichtet. Die fotopolymerisierbare Schicht polymerisiert in den von der Maske nicht mehr abgedeckten Bereichen, während in den abgedeckten Bereichen keine Polymerisation erfolgt. Hierfür werden UV-Belichter verwendet, welche verschiedene UV-Quellen umfassen können, beispielsweise UV-Röhren oder UV-LEDs.

Nach der Belichtung werden die Reste der Maske sowie die nicht polymerisierten Anteile der fotopolymerisierbaren Schicht entfernt. Dies kann unter Verwendung von einem oder mehreren Lösemitteln oder auch thermisch erfolgen. Zum Auswaschen mittels Lösemittel werden spezielle Auswaschgeräte, z.B. Bürstenwascher verwendet. Zum thermischen Entwickeln können Geräte verwendet werden, bei denen ein saugfähiges Vlies mittels einer beheizten Rolle an die belichtete Schicht gedrückt wird.

Bei Verwendung von Lösemitteln zum Entwickeln der Platte schließt sich ein Trockenschritt in einem Trockner an.

Üblicherweise wird die Oberfläche der erhaltenen Flexodruckform nach dem Trocknen nachbehandelt, beispielsweise durch Belichten der Oberfläche mit UVA- und/oder UVC-Strahlung. Hierfür werden wiederum entsprechende Belichtungsapparaturen verwendet.

Zur Herstellung von Flexodruckformen müssen die Vorrichtungen zur Durchführung der jeweiligen Verfahrensschritte vor jedem Verfahrensschritt manuell mit dem Flexodruckelement beladen werden. Nach der Durchführung des Verfahrensschrittes muss das verarbeitete Flexodruckelement der Vorrichtung manuell entnommen und dem jeweils nachfolgenden Verfahrensschritt zugeführt werden. Wegen der wiederholt notwendigen manuellen Eingriffe in das Verfahren ist die Herstellung von Flexodruckformen aufwändig.

Es sind daher Vorrichtungen vorgeschlagen worden, die die Durchführung verschiedener Verfahrensschritte in einer Apparatur miteinander kombinieren und somit die Zahl manueller Eingriffe verringern.

US 5,919,378 offenbart eine Vorrichtung zur automatisierten Verarbeitung belichteter Flexo-Runddruckformen durch Auswaschen, Trocknen und Nachbehandeln. Das Belichten ist nicht in die Vorrichtung integriert, sondern wird mittels einer separaten Vorrichtung vorgenommen. Nach dem Belichten werden die belichteten Runddruckformen manuell in die beschriebene Verarbeitungsvorrichtung geladen. Der Trockenschritt erfolgt in einer Trockeneinheit bei 60°C +/- 2 °C. Die Trockeneinheit ist mit einem Karussell ausgestattet, in welches die Sleeves eingehängt werden und auf einer ovalen Bahn im Trockenraum bewegt werden. Durch den Trockenraum wird erwärmte Luft geblasen. Die Vorrichtung verfügt weiterhin über eine Steuereinheit zur Bestimmung der Trockenzeit in Abhängigkeit des Typs der verwendeten Sleeves.

WO 2012/010459 A1 offenbart eine Vorrichtung zur in-line Produktion von Flexodruckplatten mittels einer zweistufigen Hauptbelichtung fotopolymerisierbarer Flexodruckelemente. Die Vorrichtung verfügt über eine erste Belichtungseinheit zur Belichtung mit aktinischem Licht einer Intensität ≥ 100 mW/cm² aus einer Mehrzahl von UV-LEDs und eine zweite Belichtungseinheit zur Belichtung mit einer Intensität < 100 mW/cm² mit einer von UV-LEDs verschiedenen Strahlungsquelle, bevorzugt einer UV-Röhre. Die Vorrichtung umfasst weiterhin eine Auswascheinheit und eine Trocknungseinheit sowie Transporteinheiten, welche die beschriebenen Einheiten miteinander verbinden. Optional können noch eine Einheit zur digitalen Bebilderung der Flexodruckelemente, eine Nachbehandlungseinheit sowie eine Ausgabeeinheit für die erhaltenen Flexodruckplatten vorhanden sein. Die besagten Transporteinheiten verbinden mindestens die beiden Belichtungseinheiten, die Auswascheinheit und die Trocknungseinheit. Im Hinblick auf die Transporteinheiten wird nur eine Ausführungsform genauer ausgeführt, nämlich, dass die Flexodruckelemente bzw. Platten mittels einer einzigen Transportvorrichtung durch die gesamte Anlage gefahren werden, beispielsweise mittels eines Transportbandes oder mittels einer Transportleiste.

WO 2013/156942 A1 offenbart ein Verfahren und eine Apparatur zur automatisierten Durchführung der Belichtung und des Auswaschens von fotopolymerisierbaren, digital bebilderbaren Flexodruckelementen. Die Flexodruckelemente werden dabei mittels eines Förderbandes durch die Apparatur transportiert. Die Transportgeschwindigkeit richtet sich nach den Auswaschparametern bzw. der Auswaschgeschwindigkeit. Die Belichtungsintensität wird entsprechend der Transportgeschwindigkeit angepasst. Ein Trockenschritt wird nicht beschrieben.

Unsere eigene ältere Anmeldung EP 13186585.9 offenbart eine Vorrichtung zur in-line-Belichtung von Flexodruckelementen, mit der auch unterschiedlich dicke Flexodruckelemente mit zufriedenstellenden Ergebnissen belichtet und ausgewaschen werden können. Die erfindungsgemäße Vorrichtung wird in Verfahren zur Verarbeitung plattenförmiger, digital bebilderbarer Flexodruckelemente zu Flexodruckplatten eingesetzt. Mittels der erfindungsgemäßen Vorrichtung lassen sich mindestens die Verfahrensschritte Rückseitenbelichtung, Hauptbelichtung sowie Auswaschen automatisiert durchführen. Die Vorrichtung umfasst dementsprechend mindestens ein Modul zur Durchführung einer Rückseitenvorbelichtung, ein Modul zur Durchführung einer Hauptbelichtung und ein Modul zum Auswaschen belichteter Flexodruckelemente. Die Vorrichtung umfasst weiterhin eine Transporteinheit, mit der die Flexodruckelemente durch die Vorrichtung transportiert werden, sowie eine Steuerungseinheit. Der Trockenschritt wird nicht beschrieben.

US 2013/209939 A1 beschreibt eine kombinierte Vorrichtung zur Laminierung und Belichtung fotosensitiver Druckelemente. Die Druckelemente umfassen eine Trägerschicht, eine fotohärtbare Schicht und eine laserablatierbare Schicht. Die Vorrichtung umfasst eine Laminiereinheit zum Auflaminieren einer Sauerstoffbarriereschicht auf die laserablatierbare Schicht, eine Transportvorrichtung, eine Belichtungsvorrichtung zum bildmäßigen Belichten und eine zweite Belichtungsvorrichtung zum Härten. Zum Transport der Barriereschicht sind mehrere Walzen vorgesehen.

DE 10 2010 031 527 A1 betrifft ein Verfahren und eine Vorrichtung zur Herstellung von Flexodruckformen. Das Verfahren umfasst das Erzeugen einer Maske durch digitale Bebilderung, das Belichten einer fotopolymerisierbaren reliefbildenden Schicht durch die Maske und das Entwickeln der fotopolymerisierbaren Schicht. Dazu wird eine Vorrichtung verwendet, welche eine Einheit zur Bebilderung, eine erste Belichtungseinheit, eine zweite Belichtungseinheit, eine Auswascheinheit, eine Trocknungseinheit, eine Nachbelichtungseinheit, eine Ausgabeeinheit sowie Transporteinheiten umfasst.

US 5,262,275 betrifft ein fotosensitives Druckelement mit einer IR-ablatierbaren Schicht sowie ein Verfahren zur Herstellung eines Druckelements.

EP 0 819 989 A1 beschreibt ein Verfahren zur Herstellung von zylindrischen Druckelementen, bei dem alle Verfahrensschritte automatisiert sind. Die Vorrichtung umfasst eine Speichereinheit zur Aufnahme der belichteten Druckelemente und eine Speichereinheit zur Aufnahme der fertigen Druckelemente. Zum Transport durch die Vorrichtung werden die Druckelemente auf Achsen aufgenommen und nach und nach durch die einzelnen Stationen der Vorrichtung transportiert

Bei der Konstruktion automatisch arbeitender Verarbeitungsanlagen muss berücksichtigt werden, dass die einzelnen Verarbeitungsschritte unterschiedlich schnell ablaufen, und dass der Zeitbedarf von der Art des zu verarbeitenden Flexodruckelements abhängt, insbesondere von dessen Dicke.

Insbesondere hängt die Auswaschgeschwindigkeit ganz erheblich von der Dicke der reliefbildenden Schicht ab. So lassen sich belichtete, dünne Flexodruckelemente in der Regel mit Geschwindigkeiten von bis zu 900 mm/min auswaschen, während die Auswaschgeschwindigkeiten bei dicken Flexodruckelementen erheblich geringer sind und beispielsweise nur ca. 50 mm/min möglich sein können.

Zeitbestimmender Schritt bei der Herstellung von Flexodruckplatten ist aber die Trocknung der ausgewaschenen Flexodruckplatten. Belichtung, Auswaschen sowie Nachbehandlung benötigen in der Regel jeweils 10 bis 20 Minuten. Die Trocknung wird bei handelsüblichen Flexodruckplatten bei ca. 60°C bis 65°C vorgenommen und der Trocknungsschritt dauert je nach verwendetem Plattentyp und je nach Plattendicke mindestens 45 Minuten bis hin zu 3 oder 4 Stunden.
Die lange Trocknungszeit - insbesondere bei dicken Flexodruckplatten - wird benötigt um auch Reste der hochsiedenden Auswaschmittel aus der Flexodruckplatte möglichst quantitativ zu entfernen. Es versteht sich von selbst, dass die Trockenzeit -bei gleichartigen Platten und gleichbleibender Temperaturumso länger ist, je größer die Schichtdicke der Platte ist.

Selbstredend kann die Trocknungsgeschwindigkeit prinzipiell durch die Erhöhung der Trocknungstemperatur gesteigert werden. Hierbei tritt aber das Problem auf, dass sich bei handelsüblichen Flexodruckelementen mit PET-Trägerfolien die Registergenauigkeit der Platten beim Erwärmen auf über 70°C verschlechtert, weil die PET-Trägerfolien schrumpfen können. Diese Möglichkeit der Verkürzung der Trockenzeit steht also in der Praxis nicht zur Verfügung.
Die Problematik bei der Konstruktion automatisch arbeitender Vorrichtungen zur Herstellung von Flexodruckplatten besteht also darin, dass in der Vorrichtung Verarbeitungsschritte mit deutlich unterschiedlichem Zeitbedarf miteinander kombiniert werden müssen.

Aufgabe der Erfindung war es, eine Vorrichtung zur automatisierten Verarbeitung von fotopolymerisierbaren, digital bebilderbaren Flexodruckelementen zu druckfertigen Flexodruckplatten bereit zu stellen, mit der sich mindestens die Verfahrensschritte Rückseitenbelichtung, Hauptbelichtung, Entwickeln mittels Auswaschmitteln, Trocknen und Nachbehandeln automatisiert durchführen lassen, und welche auch die Verarbeitung unterschiedlicher Flexodruckelemente, insbesondere unterschiedlich dicker Flexodruckelemente erlaubt.

Dementsprechend wurde eine Vorrichtung zur Herstellung von Flexodruckplatten ausgehend von digital bebilderbaren Flexodruckelementen umfassend mindestens eine dimensionsstabile Trägerfolie, eine fotopolymerisierbare, reliefbildende Schicht sowie eine digital bebilderte Schicht gefunden, umfassend mindestens
- eine Belichtungseinheit (1) zur Rückseitenvorbelichtung der Flexodruckelemente mittels UV-Strahlung,
- eine Belichtungseinheit (2) zur Hauptbelichtung der Flexodruckelemente mittels UV-Strahlung durch die digital bebilderte Schicht,
- eine Auswascheinheit (5) zum Entfernen der Reste der digital bebilderten Schicht sowie der nicht polymerisierten Anteile der reliefbildenden Schicht unter Verwendung von Auswaschmitteln,
- eine Trockeneinheit (7) zum Trocknen der ausgewaschenen Flexodruckplatten,
- eine Nachbehandlungseinheit (9) zum Nachbehandeln der getrockneten Flexodruckplatten mit UVA- und/oder UVC-Licht,
- eine Speichereinheit (10) zur Aufnahme der fertigen Flexodruckplatten,
- eine Steuerungseinheit (11) zur Steuerung in der Vorrichtung,
wobei die Vorrichtung mindestens zwei verschiedene Transportvorrichtungen (T) zum Transport der Flexodruckelemente bzw. Flexodruckplatten durch die Anlage umfasst. Bei einer der Vorrichtungen (T) handelt es sich um eine kontinuierlich arbeitende Transportvorrichtung (T1), die eingerichtet ist, Flexodruckelemente durch die Belichtungseinheiten (1) und (2) sowie die Auswascheinheit (5) zu transportieren, wobei
a) die Vorrichtung neben der kontinuierlichen Transporteinheit (T1) eine zweite, diskontinuierlich arbeitende Transportvorrichtung (T2, T3) umfasst, wobei die Flexodruckplatten mit der zweiten diskontinuierlich arbeitenden Transportvorrichtung (T2, T3) in die Trockeneinheit (7) in die Nachbehandlungseinheit (9) sowie die Speichereinheit (10) transportiert werden, oder
b) die Vorrichtung neben der kontinuierlichen Transporteinheit (T1) eine zweite diskontinuierlich arbeitende Transportvorrichtung (T4) und eine dritte, diskontinuierlich arbeitende Transportvorrichtung (T5) umfasst, wobei die Flexodruckplatten mit der zweiten diskontinuierlich arbeitenden Transportvorrichtung (T4) in die Trockeneinheit (7) transportiert werden und mit der dritten diskontinuierlich arbeitenden Transportvorrichtung (T5) in die Nachbehandlungseinheit (9) sowie die Speichereinheit (10) transportiert werden.

In einer Ausführungsform umfasst die Vorrichtung weiterhin eine in Transportrichtung vor der Belichtungs- und Rückseitenvorbelichtungseinheit angeordnete Einheit zur digitalen Bebilderung.

In einer bevorzugten Ausführungsform der Erfindung umfasst die Vorrichtung mindestens die kontinuierlich arbeitende Transportvorrichtung (T1), mit der die Flexodruckelemente durch die Belichtungseinheiten (1) und (2) sowie die Auswascheinheit (5) transportiert werden, sowie eine diskontinuierlich arbeitende Transportvorrichtung (T2), mit der die ausgewaschenen Flexodruckplatten in die Trockeneinheit (7), die Nachbehandlungseinheit (9) sowie die Speichereinheit (10) transportiert werden, wobei die Flexodruckplatten in einer Übergabeeinheit (6) von der Transportvorrichtung (T1) an die Transportvorrichtung (T2) übergeben werden. Weiterhin wurde ein Verfahren zur Herstellung von Flexodruckplatten unter Verwendung der besagten Vorrichtung gefunden.

Verzeichnis der Abbildungen:
- Abbildung 1: Schematische Darstellung einer Ausführungsform der erfindungsgemäßen Vorrichtung, Rückseitenvorbelichtung und Hauptbelichtung erfolgen gleichzeitig.
- Abbildung 2: Schematische Darstellung einer weiteren Ausführungsform der erfindungsgemäßen Vorrichtung, Rückseitenvorbelichtung erfolgt zuerst und dann Hauptbelichtung.
- Abbildung 3: Schematische Darstellung einer Ausführungsform der Transportvorrichtung T1.
- Abbildung 4: Schematische Darstellung einer Ausführungsform der Übergabeeinheit (6)
- Abbildung 5: Schematische Darstellung einer Ausführungsform der Übergabeeinheit (6)
- Abbildung 6: Übergabe der Platte in der Übergabeeinheit (6)
- Abbildung 7: Schematische Darstellung einer Ausführungsvorrichtung der Transportvorrichtung (T2)
- Abbildung 8: Schematische Darstellung einer Ausführungsvorrichtung der beweglichen Unterlage (17)
- Abbildung 9: Schematische Darstellung einer weiteren Ausführungsform der erfindungsgemäßen Vorrichtung, Rückseitenvorbelichtung und Hauptbelichtung erfolgen gleichzeitig.

Zu der Erfindung ist im Einzelnen das Folgende auszuführen:
Im Folgenden werden die Begriffe "Flexodruckplatte", "Flexodruckform" oder "Klischee" für eine bereits vernetzte Druckform verwendet. Der Begriff "Flexodruckelement" wird in üblicher Art und Weise für das fotopolymerisierbare Ausgangsmaterial verwendet, welches zur Herstellung von Flexodruckformen bzw. Flexodruckplatten eingesetzt wird.

### Erfindungsgemäße Vorrichtung

Die erfindungsgemäße Vorrichtung wird in Verfahren zur Verarbeitung plattenförmiger, digital bebilderbarer Flexodruckelemente zu Flexodruckplatten unter Verwendung von Auswaschmitteln eingesetzt.

Plattenförmige, digital bebilderbare Flexodruckelemente sind dem Fachmann prinzipiell bekannt, und sie sind kommerziell erhältlich. Beispiele derartiger Flexodruckelemente sind beispielsweise in US 5,262,275, EP-A 1 069 475, WO 2008/095994 A1, WO 2009/141256 A1 oder WO 2012/010459 A1 beschrieben. Die digital bebilderbaren Flexodruckelemente umfassen mindestens eine dimensionsstabile Trägerfolie, eine reliefbildende, fotopolymerisierbare Schicht, bevorzugt eine in organischen Auswaschmitteln auswaschbare reliefbildende, fotopolymerisierbare Schicht sowie eine digital bebilderbare Schicht, bevorzugt eine laserablatierbare Maskenschicht. Ist Rückseitenvorbelichtung vorgesehen, sollte die Tägerfolie zumindest eine gewisse UV-Transparenz aufweisen. Sie können darüber hinaus selbstverständlich noch weitere Schichten umfassen, wie beispielsweise Klebeschichten, Sauerstoff-Sperrschichten oder eine Schutzfolie auf der digital bebilderbaren Schicht.

Mittels der erfindungsgemäßen Vorrichtung lassen sich mindestens die Verfahrensschritte Rückseitenbelichtung, Hauptbelichtung, Entwickeln mittels Auswaschmitteln, Trocknen und Nachbehandeln automatisiert durchführen.

Die erfindungsgemäße Vorrichtung umfasst dementsprechend mindestens
- eine Belichtungseinheit (1) zur Rückseitenvorbelichtung der Flexodruckelemente mittels UV-Strahlung,
- eine Belichtungseinheit (2) zur Hauptbelichtung der Flexodruckelemente mittels UV-Strahlung durch die digital bebilderte Schicht,
- eine Auswascheinheit (5) zum Entfernen der Reste der digital bebilderten Schicht sowie der nicht polymerisierten Anteile der reliefbildenden Schicht unter Verwendung von Auswaschmitteln,
- eine Trockeneinheit (7) zum Trocknen der ausgewaschenen Flexodruckplatten,
- eine Nachbehandlungseinheit (9) zum Nachbehandeln der getrockneten Flexodruckformen mit UVA- und/oder UVC-Licht,
- eine Speichereinheit (10) zur Aufnahme der fertigen Flexodruckplatten, und
- eine Steuerungseinheit (11) zur Steuerung in der Vorrichtung.

Optional kann die Vorrichtung weiterhin eine in Transportrichtung vor der Belichtungs- und Rückseitenvorbelichtungseinheit angeordnete Einheit zur digitalen Bebilderung umfassen. Hierbei kann es sich z.B. um eine Vorrichtung zum Einschreiben einer Maske in die digital bebilderbare Schicht mittels eines Lasers handeln, beispielsweise um einen Flachbettlaser.

Optional können weiterhin noch weitere Einheiten vorhanden sein, beispielsweise Einheiten zum automatischen Beladen der erfindungsgemäßen Vorrichtung mit Flexodruckelementen oder zum automatischen Entladen der Vorrichtung von fertigen Flexodruckplatten.
Erfindungsgemäß umfasst die Vorrichtung mindestens zwei verschiedene Transportvorrichtungen (T) zum Transport der Flexodruckelemente bzw. Flexodruckplatten durch die Anlage. Eine Transportvorrichtung transportiert ein Flexodruckelement bzw. eine Flexodruckplatte von einer Bearbeitungseinheit zu mindestens einer weiteren Bearbeitungseinheit. Selbstverständlich kann eine Transporteinheit auch den Transport zwischen mehr als zwei nacheinander angeordneten Bearbeitungseinheiten umfassen.

Bei den Transportvorrichtungen (T) kann es sich um kontinuierlich oder diskontinuierliche arbeitende Transportvorrichtungen handeln.

Der Begriff "kontinuierlich" soll bedeuten, dass die Transportvorrichtung die Flexodruckelemente bzw. Flexodruckplatten mittels einer kontinuierlichen Bewegung durch die Vorrichtung transportiert, und zwar auch während der jeweilige Bearbeitungsschritt, beispielsweise Belichten oder Auswaschen, vorgenommen wird, wobei die Geschwindigkeit nicht notwendigerweise gleichförmig sein muss. Die Flexodruckelemente bzw. Flexodruckplatten sind während der Bearbeitung also aufgrund des Einwirkens der Transportvorrichtung in Bewegung.

Bei kontinuierlichen Transportvorrichtungen kann es sich beispielsweise um Transportbänder handeln oder um Vorrichtungen, bei denen die Flexodruckelemente bzw. -platten mittels Transportketten, Spindeln oder dergleichen durch die Vorrichtung gezogen werden.

Der Begriff "diskontinuierlich" soll bedeuten, dass die Transportvorrichtung die Flexodruckelemente bzw. Flexodruckplatten von einer zur nächsten Bearbeitungseinheit transportiert, sie während der Verarbeitung von der Transportvorrichtung aber nicht bewegt werden. Dies schließt nicht aus, dass sie innerhalb der jeweiligen Verarbeitungseinheit von einem Mechanismus der Verarbeitungseinheit bewegt werden können. Beispielsweise können Flexodruckplatten in der Trockeneinheit während des Trocknens im Trockenraum umlaufen.

Bei diskontinuierlichen Vorrichtungen kann es sich beispielsweise um verschiebbare Greifvorrichtungen oder um aus- und einfahrbare Greifarme handeln, welche die Flexodruckelemente bzw. -platten von einer Bearbeitungseinheit in die nächste schieben.

Kontinuierliche und diskontinuierliche Transportvorrichtungen können selbstverständlich miteinander kombiniert werden. Beispielsweise kann die Vorrichtung eine kontinuierlich arbeitende Transportvorrichtung umfassen, mit der die Flexodruckelemente durch die Belichtungseinheiten (1) und (2) sowie die Auswascheinheit (5) transportiert werden, und anschließend erfolgt der Weitertransport mittels einer oder mehrerer diskontinuierlicher Transportvorrichtungen.

Zur Verarbeitung in der beschriebenen, erfindungsgemäßen Vorrichtung werden die bereits digital bebilderten Flexodruckelemente in eine erste Transportvorrichtung eingeführt und die verarbeiteten Flexodruckelemente können nach dem Verarbeiten in der Vorrichtung der letzen Transportvorrichtung entnommen werden. Der Begriff "digital bebildert" bedeutet, dass in die digital bebilderbare Schicht bereits eine Maske eingeschrieben wurde, d.h. das Flexodruckelement ist vorbereitet zur bildmäßigen Belichtung.

Sofern die Vorrichtung über eine Einheit zur digitalen Bebilderung verfügt, werden digital bebilderbare Flexodruckelemente in eine erste Transportvorrichtung eingeführt und zunächst einer Einheit zur digitalen Bebilderung zugeführt und dann weiter verarbeitet.

### Erste bevorzugte Ausführungsform

### Modul "Belichten - Auswaschen"

In einer ersten bevorzugten Ausführungsform handelt es sich bei einer der Vorrichtungen (T) um eine kontinuierlich arbeitende Transportvorrichtung (T1), mit der die Flexodruckelemente durch die Belichtungseinheiten (1) und (2) sowie die Auswascheinheit (5) transportiert werden.

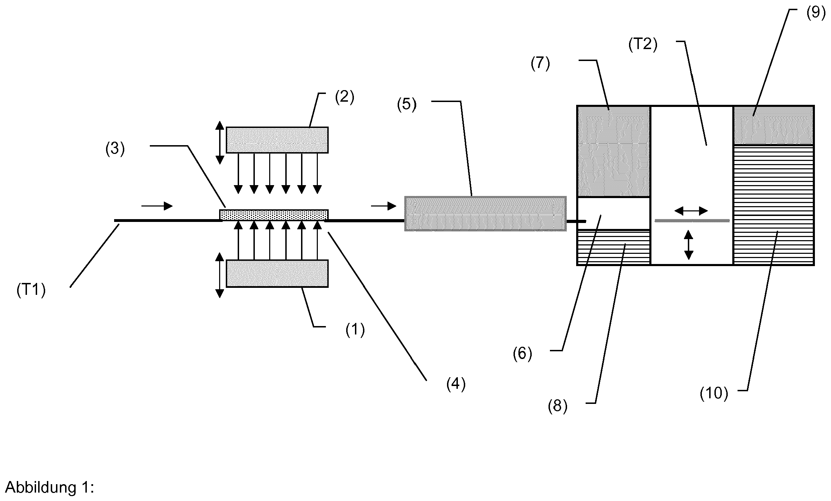

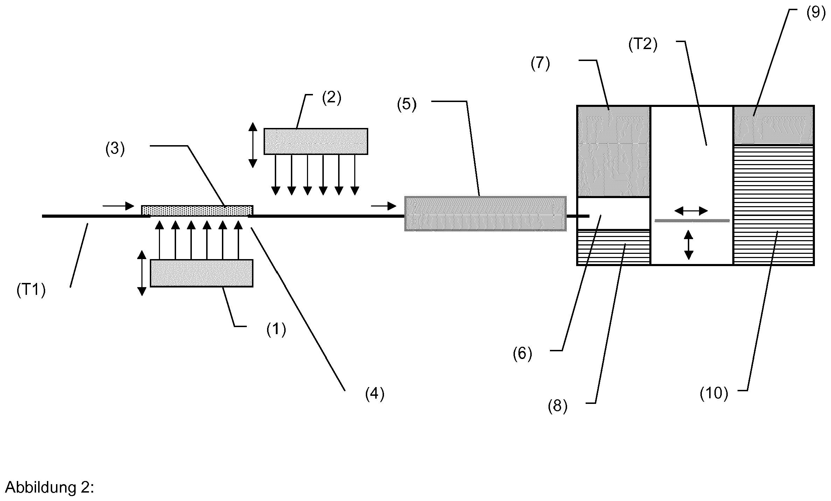

Die Abbildungen 1 und 2 zeigen Gesamtansichten zweier erfindungsgemäßer Vorrichtungen, welche jeweils über eine kontinuierliche Transportvorrichtung (T1) verfügen.

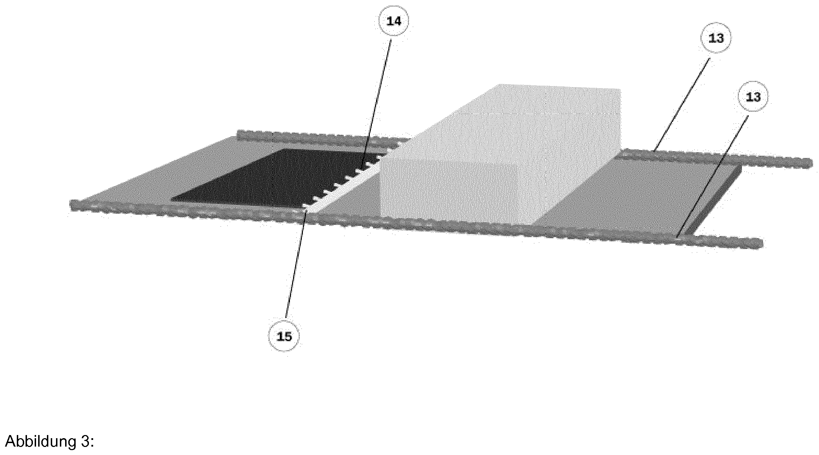

Eine Ausführungsform der Transportvorrichtung (T1) ist schematisch in Abbildung 3 dargestellt.

Die dargestellte Transportvorrichtung (T1) umfasst zwei parallel zueinander in einem Abstand a voneinander in Transportrichtung verlaufende Transportelemente (13). Hierbei kann es sich beispielsweise um umlaufende Transportketten, umlaufende Zahnriemen oder um rotierende Spindeln handeln, die jeweils von einer geeigneten Antriebseinheit angetrieben werden.

Die Transportvorrichtung (T1) umfasst weiterhin Transportleisten (14), deren Länge mindestens a beträgt. Die Transportleisten können senkrecht zu den beiden Transportelementen mit ihren jeweiligen Enden (15) auf die beiden Transportelemente aufgelegt werden und werden mittels geeigneter Mitnehmer von den Transportelementen in Transportrichtung bewegt.

Die Art der Mitnehmer hängt dabei von der Art der Transportelemente ab. Handelt es sich um Ketten oder Zahnriemen können Mitnehmer, beispielsweise Stifte, jeweils paarweise gegenüber angeordnet werden. Handelt es sich bei den Transportelementen um Spindeln, dann können die Mitnehmer in den seitlichen Enden der Transportleisten angeordnet sein.

Der Abstand a voneinander begrenzt die maximale Breite der Flexodruckelemente, welche mit der erfindungsgemäßen Vorrichtung verarbeitet werden können. Zu verarbeitende Flexodruckelemente können schmaler, aber nicht breiter sein als der Abstand a.

Die Transportvorrichtung (T1) kann weiterhin eine zwischen den beiden Transportelementen angeordnete Auflage aufweisen, auf der die Flexodruckelemente aufliegen. Die Auflage muss nicht durchgängig sein.

Zur Verarbeitung in der erfindungsgemäßen Apparatur werden die bebilderten Flexodruckelemente mit der in Transportrichtung vorderen Kante an einer Transportleiste befestigt und anschließend am Anfang der Transportvorrichtung (T1) auf die beiden Transportelemente aufgelegt. Am Ende der Transportvorrichtung (T1) werden die ausgewaschenen Flexodruckplatten von einer weiteren Transportvorrichtung übernommen.
Das Befestigen der Transportleisten (14) an den Flexodruckelementen kann beispielsweise erfolgen, indem man die Flexodruckelemente mittels einer Plattenstanze entlang der Einlaufkante locht und an dem Stanzbild entsprechend angeordneten Pins der Transportleiste einhängt. Bei der Transportleiste kann es sich in einer anderen Ausführungsform um eine Klemmleiste handeln, in die die Flexodruckelemente eingeklemmt werden können.

Bei der Plattenstanze kann es sich um eine externe, separat angeordnete Plattenstanze handeln und das Einhängen in die Transportvorrichtung kann manuell erfolgen.

Die erfindungsgemäße Vorrichtung kann aber auch eine Beladungseinheit (12) umfassen, in welche man nur die zu verarbeitenden Flexodruckelemente einführt und die Flexodruckelemente automatisch gelocht und in die Transportvorrichtung eingehängt werden.

Dies kann beispielsweise dadurch geschehen, dass die Transportleiste (14) in eine Aussparung im Eingabebereich gelegt wird und die Flexodruckelemente in die Eingabevorrichtung bis zu einer Stoppleiste automatisch oder per Hand eingeführt werden. Die Platte kann an der Vorderkante mittels eines Niederhalters fixiert und gleichzeitig gestanzt werden. Danach wird die Stoppleiste wieder nach oben weggeführt. Die Transportleiste wird nun passgenau unter die Platte verfahren, sodass die gestanzten Löcher exakt über den Pins der Transportleiste zu liegen kommen. Danach wird die Transportleiste nach oben gedrückt und die Verbindung hergestellt.

Das Einlegen der Transportleiste kann manuell oder auch automatisch aus einer Vorratseinheit erfolgen. Als weitere Option kann der automatische Transport der Transportleisten vom Ausgabebereich in die Vorratseinheit über ein Förderband oder ein anderes geeignetes Transportsystem vorgesehen werden.

Die an der Vorderseite mit der Transportleiste (14) versehenen Flexodruckelemente können anschließend eine nach der anderen an den Beginn der Transportvorrichtung (T1) herangefahren werden. Sie werden dann automatisch von den Mitnehmern erfasst und transportiert.

Die bevorzugte erfindungsgemäße Vorrichtung umfasst weiterhin eine oberhalb der Transportvorrichtung (T1) angeordnete Hauptbelichtungseinheit (2) sowie eine unterhalb der Transportvorrichtung angeordnete Belichtungseinheit zur Rückseitenvorbelichtung (1).

In einer Ausführungsform der Erfindung können die Hauptbelichtungseinheit (2) sowie die Rückseitenbelichtungseinheit (1) höhenverstellbar angeordnet sein, so dass der Abstand der Belichtungseinheit zur Plattenoberfläche variiert werden kann. Auf diese Art und Weise lässt sich die Belichtungsintensität auf einfache Art und Weise variieren.

Im Bereich des Moduls "Rückseitenvorbelichtung" (1) kann die Transportvorrichtung eine Auflage aus einem UV-transparenten Material aufweisen, beispielsweise aus UV-transparentem Glas, Quarzglas oder PMMA.
Bei den UV-Lichtquellen in der Hauptbelichtungseinheit (2) und der Einheit zur Rückseitenvorbelichtung (1) kann es sich prinzipiell um beliebige Lichtquellen handeln, beispielsweise UV-Röhren oder UV-LEDs, wobei UV-LEDs in prinzipiell bekannter Art und Weise in Form von Diodenarrays angeordnet sind. Erfindungsgemäß ist die Leistung der UV-Lichtquellen regelbar. Bevorzugt handelt es sich um UV-LEDs. In einer Ausführungsform kann die Hauptbelichtungseinheit eine Diffusionsscheibe umfassen. Hierdurch lässt sich UV-Licht streuen und die bestrahlte Fläche vergrößern oder die Gleichmäßigkeit der Strahlungsintensität über der bestrahlten Fläche verbessern.

Der Abstand zwischen der Oberfläche des Flexodruckelements und der UV-LEDs kann klein gehalten werden und beträgt üblicherweise 2 bis 100 mm, bevorzugt 2 bis 20 mm und beispielsweise 2 bis 10 mm. Die Strahlung von UV-LEDs weist praktisch keinen IR-Anteil auf, so dass auch eine hohe Intensität bei einem geringen Abstand zum Flexodruckelement möglich ist, ohne dass eine zu hohe Wärmebelastung des Flexodruckelements zu befürchten ist.

Bei anderen UV-Quellen müssen aufgrund der IR-Anteile in der emittierten Strahlung naturgemäß größere Abstände eingehalten werden.

Die Hauptbelichtungseinheit (2) und die Einheit zur Rückseitenvorbelichtung (1) können wie in Abbildung 1 dargestellt einander gegenüber liegend angeordnet sein, so dass Hauptbelichtung und Rückseitenvorbelichtung gleichzeitig erfolgen. In einer weiteren, in Abbildung 2 dargestellten Ausführungsform der erfindungsgemäßen Vorrichtung kann die Einheit zur Rückseitenvorbelichtung (1) in Transportrichtung vor der Hauptbelichtung (2) angeordnet werden.

Die Belichtung sollte zur Vermeidung von Streulichteffekten in den Randbereichen des Flexodruckelements nur in der Breite des Flexodruckelements erfolgen. Vorteilhaft weist der Belichter daher Blenden auf, welche die Belichtungsbreite auf die Breite des Flexodruckelements reduzieren.

Die erfindungsgemäße Vorrichtung umfasst weiterhin mindestens eine Auswascheinheit (5). Die Einheit ist so angeordnet, dass ein bildmäßig belichtetes Flexodruckelement nach Rückseitenvorbelichtung und Hauptbelichtung in die Auswascheinheit (5) eintritt. In der Auswascheinheit werden die Reste der digital bebilderbaren Schicht, beispielsweise Reste der laserablatierbaren Maskenschicht sowie der nicht polymerisierten Anteile der reliefbildenden Schicht unter Verwendung von geeigneten Auswaschmitteln entfernt. Sofern das eingesetzte Flexodruckelement noch weitere, oberhalb der reliefbildenden Schicht angeordnete Schichten umfasst, werden diese ebenfalls entfernt.

Die Art der Auswaschmittel richtet sich nach der Natur der zu verarbeitenden Flexodruckelemente. Je nach Art der reliefbildenden Schicht können wässrige Auswaschmittel oder organische Auswaschmittel verwendet werden. Bei Auswaschmitteln kann es sich selbstverständlich auch um Gemische verschiedener Lösemittel sowie optional Zusatzstoffen wie beispielsweise Antistatika handeln.

Die Auswascheinheit kann hierzu in üblicher Art und Weise eine Wanne zur Aufnahme der Auswaschmittel, Zu- und Abläufe für Auswaschmittel sowie Auswaschbürsten umfassen. Im Bereich unterhalb der Bürsten ist vorteilhaft eine Auflage für die Flexodruckelemente angebracht, beispielsweise ein Lochblech. In einer alternativen Ausführungsform kann sich unter jeder Bürsteneinheit ein Blech befinden, im Raum zwischen den Bürsteneinheiten aber keine Auflage. Auf diese Art und Weise kann das Lösemittel besser abfließen. Die auszuwaschenden Flexodruckelemente können mittels der geschilderten Transportvorrichtung durch die Wanne gezogen werden. Die Auswaschbürsten dienen zur mechanischen Unterstützung des Auswaschvorganges.
Die erfindungsgemäße Vorrichtung kann auch mehr als eine Auswascheinheit (5) umfassen, insbesondere zwei Auswascheinheiten, wobei bevorzugt jede der Auswascheinheiten über einen eigenen Lösemittelkreislauf verfügt. Diese Konstruktion ermöglicht es, das belichtete Flexodruckelement mit unterschiedlichen Auswaschmitteln auszuwaschen.

Hierdurch kann beispielsweise eine unterschiedliche Polarität von laserablatierbarer Schicht und reliefbildender Schicht berücksichtigt werden. Handelsübliche, digital bebilderbare Flexodruckelemente umfassen häufig eine laserablatierbare Maskenschicht, die aufgrund der üblicherweise verwendeten Bindemittel, beispielsweise weichelastischer Polyamide, deutlich polarer ist, als die in organischen Lösemitteln lösliche fotopolymerisierbare Schicht. Bei Verwendung einer Vorrichtung mit zwei Auswascheinheiten kann man vorteilhaft die Reste der laserablatierbaren Maskenschicht mit einem polaren Auswaschmittel auswaschen und die bildmäßig belichtete fotopolymerisierbare Schicht mit einem unpolaren Auswaschmittel.

Erfindungsgemäß umfasst die Vorrichtung weiterhin eine Steuerungseinheit (11) zur Steuerung der Vorrichtung. Mit der Steuerungseinheit (11) lassen sich mindestens die Geschwindigkeit der Transportvorrichtung (T1), die Leistung und/oder die Belichtungszeit der Einheit zur Rückseitenvorbelichtung (1) und die Leistung und/oder die Belichtungszeit der Hauptbelichtungseinheit (2) steuern. Da die Auswascheinheit (5) eine festgelegte Geometrie hat, ist mittels der Geschwindigkeit der Transportvorrichtung (T1) die zur Verfügung stehende Auswaschzeit des belichteten Flexodruckelements festgelegt. Selbstverständlich können optional auch noch weitere Funktionen der Vorrichtung durch die Steuerungseinheit gesteuert werden.

### Modul "Trocknen - Nachbehandeln"

In der ersten bevorzugten Ausführungsform umfasst die erfindungsgemäße Vorrichtung neben der Transportvorrichtung (T1) eine zweite, diskontinuierlich arbeitende Transportvorrichtung (T2), mit der die ausgewaschenen Flexodruckplatten mindestens in die Trockeneinheit (7), die Nachbehandlungseinheit (9) sowie die Speichereinheit (10) transportiert werden, wobei die ausgewaschenen aber noch feuchten Flexodruckplatten in einer Übergabeeinheit (6) von der Transportvorrichtung (T1) an die Transportvorrichtung (T2) übergeben werden.

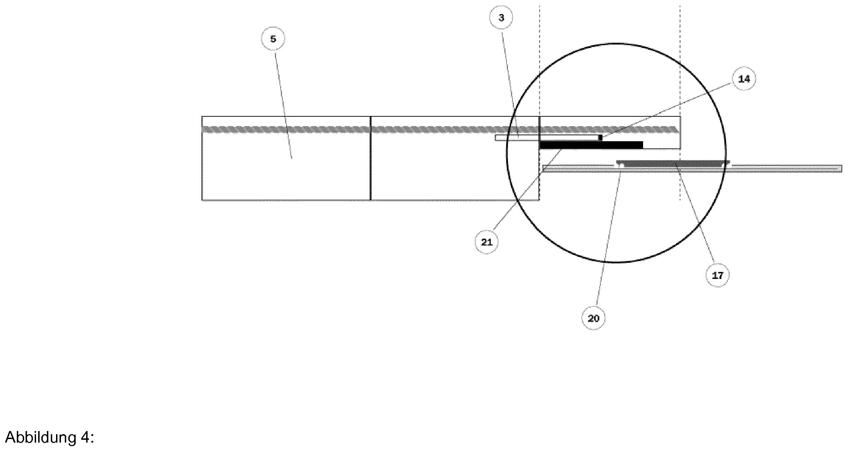

Diese Ausführungsform ist schematisch in den Abbildungen 1 und 2 wiedergegeben, Details finden sich in den Abbildungen 4, 5, 6, 7 und 8.

In der Übergabeeinheit (6) werden die Flexodruckplatten der Transportvorrichtung (T1) entnommen und auf einer beweglichen Unterlage (17) abgelegt. Die bewegliche Unterlage (17) dient als Träger für die Flexodruckplatte und wird von der Transportvorrichtung (T2) bewegt.

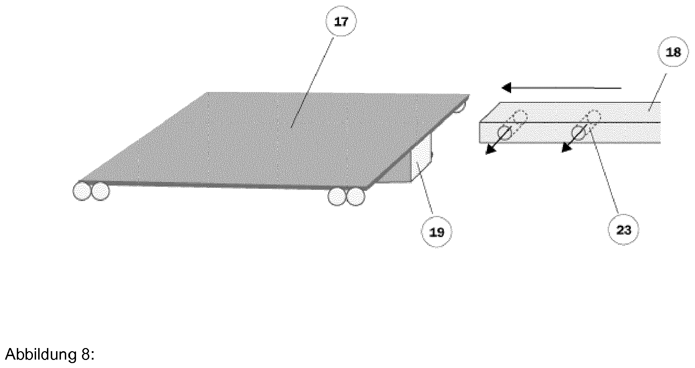

In einer bevorzugten Ausführungsform der Erfindung ist die bewegliche Unterlage (17) auf Rollen gelagert (siehe Abbildung 8). Bevorzugt umfasst die bewegliche Unterlage weiterhin auf der Unterseite eine Kupplung (19), welche zum horizontalen Verschieben der beweglichen Unterlage (17) von einem geeigneten Mechanismus der Transportvorrichtung (T2) ergriffen werden kann. Bei dieser Ausführungsform umfassen die Übergabeeinheit (6), der Trockner (7), die Nachbehandlungseinheit (9) und -sofern vorhanden- die Speichereinheit (10) jeweils Führungsschienen (20), auf denen die Rollen aufweisende bewegliche Unterlage (17) horizontal verschoben werden kann.

Selbstverständlich sind alternative Ausführungsformen der beweglichen Unterlage (17) möglich, beispielsweise eine bewegliche Unterlage, die keine Rollen aufweist, sondern in den Führungsschienen (20) gleitet.

Die notwendigen leeren, beweglichen Unterlagen (17) können beispielsweise in der Speichereinheit (10) vorrätig gehalten werden. In einer Ausführungsform der Erfindung kann die Vorrichtung zusätzlich eine Lagereinheit (8) für bewegliche Unterlagen (17) umfassen, die bevorzugt unter der Übergabeeinheit (6) platziert wird.

In einer bevorzugten Ausführungsform sind die Übergabeeinheit (6), die Trockeneinheit (7) sowie optional die Lagereinheit (8) -in Verarbeitungsrichtung gesehen- vor der Transporteinheit (T2) angeordnet, wobei die Übergabeeinheit (6) in der Mitte, die Trockeneinheit (7) oberhalb und die Lagereinheit (8) -sofern vorhanden- unterhalb der Übergabeeinheit angeordnet sind, und die Nachbehandlungseinheit (9) und die Speichereinheit (10) sind -in Verarbeitungsrichtung gesehen- hinter der Transporteinheit (T2) angeordnet, wobei bevorzugt die Nachbehandlungseinheit (9) oberhalb der Speichereinheit (10) angeordnet ist.

Die Transportvorrichtung (T2) umfasst eine Trägerkonstruktion (24), in welcher die funktionalen Elemente der Transportvorrichtung (T2) untergebracht sind. Die Transportvorrichtung (T2) ermöglicht das Verschieben der beweglichen Unterlagen für die Flexodruckplatten in vertikaler und horizontaler Richtung. Auf den beweglichen Unterlagen (17) kann -je nach Arbeitsgang- jeweils eine Flexodruckplatte aufliegen, oder es kann sich um eine leere bewegliche Unterlage (17) handeln. Das vertikale Verschieben erfolgt innerhalb der Trägerkonstruktion (24) mittels eines geeigneten Antriebs. Das horizontale Verschieben erfolgt beispielsweise mittels aus- und einfahrbarer Arme, welche mittels eines geeigneten Mechanismus, beispielsweise mechanisch oder magnetisch, an die beweglichen Unterlagen (17) ankuppeln können. Auf diese Art und Weise können die beweglichen Unterlagen aus der Transportvorrichtung (T2) in die oben geschilderten, benachbarten Verarbeitungseinheiten verschoben und wieder herausgeholt werden.

Die Trockeneinheit (7) umfasst in der Regel mehrere übereinander angeordnete Trockenfächer, welche jeweils eine -auf einer beweglichen Unterlage (17) aufliegende- Flexodruckplatte aufnehmen können. Es können also mehrere Flexodruckplatten gleichzeitig getrocknet werden. Die Trockenfächer verfügen jeweils über einen Mechanismus, beispielsweise eine pneumatisch betriebene Klappe zum Verschließen und Öffnen des Trockenfachs. Die Trockeneinheit (7) kann beispielsweise 5 bis 15 Trockenfächer umfassen.

Bevorzugt werden die Trockenfächer jeweils autark betrieben, d.h. jedes Trockenfach verfügt über eigene Heizelemente, Regelung und Überwachung. Vorteilhaft können somit die Trockenbedingungen, insbesondere die Temperatur, für jede zu trocknende Flexodruckplatte individuell eingestellt werden, oder es können einzelne Trockenfächer bei einem Defekt oder zur Energieeinsparung bei geringer Auslastung abgeschaltet werden.

Auch die Speichereinheit (10) sowie die Lagereinheit (8) verfügen über die Möglichkeit, übereinander angeordnet mehrere bewegliche Unterlagen (17) aufzunehmen. Die Speichereinheit (10) kann beispielweise 10 bis 20 bewegliche Unterlagen (17) aufnehmen. Die Speichereinheit kann -in einem geeigneten Gestell- übereinander angeordnete Schienen aufweisen, in die die beweglichen Unterlagen eingeschoben werden.

In der Nachbehandlungseinheit (9) kann die Oberseite ausgewaschener und getrockneter Flexodruckplatten in prinzipiell bekannter Art und Weise mit UVA- und/oder UVC-Licht bestrahlt werden. Als UV-Lichtquellen kommen beispielsweise UV-Röhren oder UV-LEDs in Frage.

In der Übergabeeinheit (6) werden die ausgewaschenen Flexodruckplatten der Transportvorrichtung (T1) entnommen und auf beweglichen Unterlagen (17) abgelegt. Der Vorgang ist schematisch in den Abbildungen 4, 5 und 6 dargestellt. Abbildung 4 zeigt schematisch die Übergabeeinheit (6) im Querschnitt. Eine ausgewaschene Flexodruckplatte (3) mit angebrachter Transportleiste (14) liegt am Ende der Auswascheinheit (5) noch auf der Auflageebene (21) der Auswascheinheit (5). Unterhalb des Endes der Transporteinheit (T1) (dargestellt ist in der Perspektive von Abbildung (4) nur eine Spindel, welche die Transportleiste (14) bewegt) befindet sich eine bewegliche Unterlage (17), welche in der Führungsschiene (20) gehalten wird, und auf der Führungsschiene horizontal bewegt werden kann. Der Höhenunterschied zwischen der Auflageebene (21) und der Oberfläche der beweglichen Unterlage (17) beträgt nur wenige mm, beispielweise 10 mm bis 40 mm.

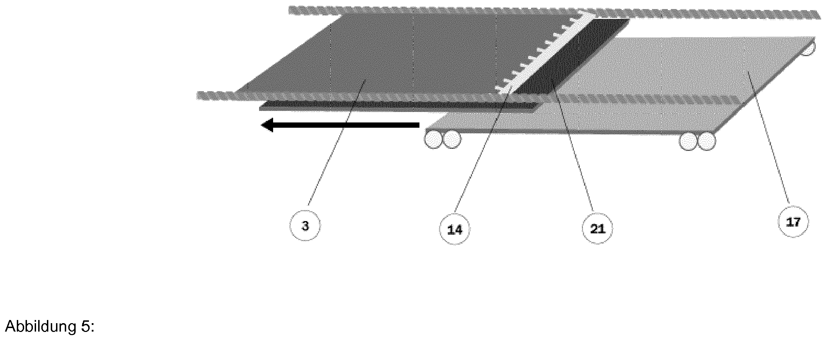

Abbildung 5 zeigt die Übergabeeinheit (6) in perspektivischer Darstellung. Die ausgewaschene Flexodruckplatte (3) ist mit der Transportleiste (14) in die Transportvorrichtung (T1) eingehängt (sichtbar sind in dieser Perspektive zwei Spindeln, in die die Transportleiste zum Transport eingehängt ist) und liegt noch auf der Auflageebene (21) der Auswascheinheit (5) auf. Eine bewegliche Unterlage (17) befindet sich darunter.

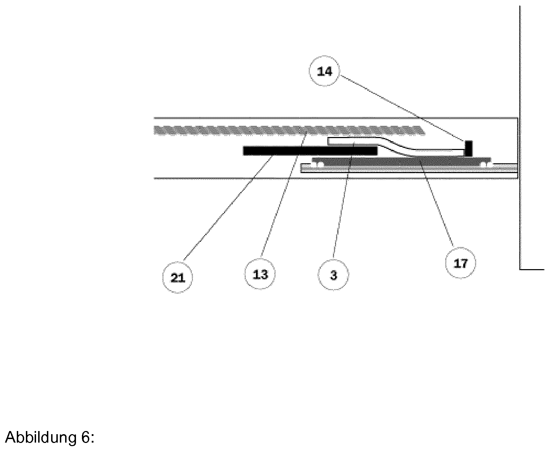

Abbildung 6 zeigt den eigentlichen Transfer. Die ausgewaschene Flexodruckplatte (3) wird von der Transportvorrichtung (T1) über das Ende der Auflageebene (21) der Auswascheinheit hinaus gezogen. Am Ende der Transportvorrichtung löst sich die Transportleiste (14) von der Transportvorrichtung (T1) und gleitet mitsamt verbundener Flexodruckplatte (3) auf die bewegliche Unterlage (17). Die bewegliche Unterlage (17) mit aufliegender, ausgewaschener Flexodruckplatte (3) kann dann von der Transportvorrichtung (T2) erfasst und in die Transportvorrichtung (T2) eingezogen werden, beispielsweise mittels der oben geschilderten Greifvorrichtung.

In einer Ausführungsform der Erfindung umfasst die Transportvorrichtung (T2) eine innerhalb der Trägerkonstruktion (24) horizontal gelagerte Halterung (16), welche eine bewegliche Unterlage (17) für Flexodruckplatten aufnehmen kann, und die mittels eines geeigneten Antriebs vertikal innerhalb der Trägerkonstruktion bewegt werden kann.

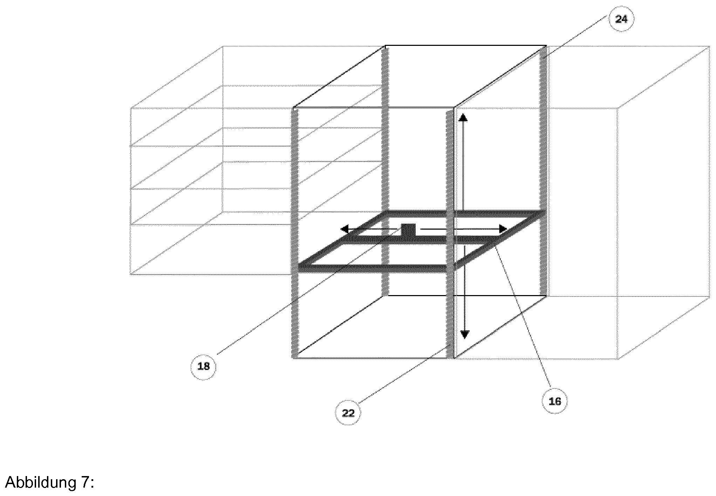

Eine solche Ausführungsform ist in Abbildung 7 schematisch dargestellt. Die Trägerkonstruktion kann insbesondere quaderförmig sein, wobei die Kanten des Quaders geeignete Träger darstellen. Die Trägerkonstruktion (24) kann beispielweise vier senkrecht verlaufende, drehbare Spindeln umfassen, welche synchron von einem geeigneten Antrieb angetrieben werden. Die horizontal gelagerte Halterung (16) kann passende Gegengewinde zu den Spindeln aufweisen, in denen die Spindeln verlaufen, so dass die Halterung (16) beim Drehen der Spindeln die Höhe ändert. Die horizontale Halterung (16) kann insbesondere Führungsschiene (20) aufweisen, auf denen bewegliche Unterlagen (17) festgehalten werden können. Für den bevorzugten Fall, dass die beweglichen Unterlagen (17) Rollen aufweisen, können die beweglichen Unterlagen in den Führungsschienen rollen.

Die Halterung (16) umfasst weiterhin eine Verschiebevorrichtung (18), mit der bewegliche Unterlagen (17) jeweils horizontal aus der Transportvorrichtung (T2) in die Übergabeeinheit (6), den Trockner (7), die Nachbehandlungseinheit (9) sowie die Speichereinheit (10) verschoben werden und/oder den genannten Einheiten wieder entnommen werden können.

Zum Halten der beweglichen Unterlage (17) umfassen die Halterung (16), die Übergabeeinheit (6), der Trockner (7), die Nachbehandlungseinheit (9) und die Speichereinheit (10) jeweils Führungsschienen (20), auf denen die bewegliche Unterlage (17) horizontal verschoben werden kann. Die Führungsschienen können in den jeweiligen Einheiten weiterhin jeweils Stopper umfassen, mit welchen die Position der beweglichen Unterlage fixiert werden kann. Hierbei kann es sich beispielsweise um pneumatisch betriebene Stopper handeln, welche die Laufrollen oder Kufen der beweglichen Unterlagen (17) blockieren.
Die Verschiebevorrichtung (18) umfasst eine automatisch gesteuerte Ankupplungsvorrichtung (23), welche zum Verschieben reversibel mit entsprechenden Kupplungen (19) auf der Unterseite der beweglichen Unterlage (17) verbunden werden kann. Eine derartige Ankupplungsvorrichtung kann beispielsweise magnetisch oder mechanisch funktionieren. Ein Beispiel einer mechanischen Ankupplung ist schematisch in Abbildung (8) dargestellt. Die Verschiebevorrichtung (18) fährt nach dem Einfahren in die Kupplung (19) auf der Unterseite der beweglichen Unterlage (17) Zapfen aus, so dass die Verschiebevorrichtung (18) fest mit der beweglichen Unterlage (17) verbunden ist.

In einer Ausführungsform der Erfindung erfolgt der Transport der Flexodruckplatten mittels der Transportvorrichtung (T2) folgendermaßen: Die Transportvorrichtung (T2) zieht eine bewegliche Unterlage (17) mit einer ausgewaschenen, aber noch feuchten Flexodruckplatte aus der Übergabeeinheit (6) in die Transportvorrichtung (T2) ein. Dort wird sie nach oben bewegt und nach Erreichen der richtigen Höhe in ein leeres Trockenfach der Trockeneinheit (7) verschoben. Die Trockenzeit richtet sich nach der Art des zu trocknenden Flexodruckelements und den Trockenbedingungen und kann für jedes zu trocknende Flexodruckelement individuell eingestellt werden. Nach dem Ende der Trocknung wird die bewegliche Unterlage (17) mit einer getrockneten Flexodruckplatte wieder aus dem Trockenfach in die Transportvorrichtung (T2) eingezogen, sofern erforderlich auf eine andere Höhe gefahren und dann in die Nachbehandlungseinheit (9) zur Nachbehandlung mit UVA- und/oder UVC-Licht geschoben. Nach der Nachbehandlung wird die bewegliche Unterlage mit der Flexodruckplatte der Nachbehandlungseinheit (9) entnommen, in der Transportvorrichtung (T2) nach unten bewegt und in ein leeres Fach der Speichereinheit (10) verschoben.

Die fertige Flexodruckplatte kann der Speichereinheit manuell entnommen werden. In einer Ausführungsform werden die beweglichen Unterlagen von der Transportvorrichtung (T2) in eine Ausgabeeinheit verschoben.

Nach dem Entnehmen der fertigen Flexodruckplatte kann die Transportleiste (14) manuell entfernt werden. Die erfindungsgemäße Vorrichtung kann aber auch mit einer Vorrichtung zum automatischen Entfernen der Transportleiste (14) ausgestattet sein. Hierbei wird die Transportschiene angewinkelt und gegen eine Konterkonstruktion mit Aussparungen für die Transportnippel gedrückt.
In einer Ausführungsform der Erfindungen können die leeren Transportleisten automatisch über ein Förderband oder eine geeignete Transportvorrichtung in eine Vorratseinheit am Anfang der Anlage zurück transportiert werden.

Leere bewegliche Unterlagen (17) zur Aufnahme einer neuen Flexodruckplatte aus der Übergabeeinheit (6) können -sofern vorhanden- der separaten Lagereinheit (8) entnommen und mittels der Transporteinheit (T2) in die Übergabeeinheit (6) transferiert werden. Alternativ können leere bewegliche Unterlagen (17) auch in Fächern der Speichereinheit (10) gelagert werden und von dort aus mittels der Transporteinheit (T2) in die Übergabeeinheit (6) transferiert werden.

### Zweite bevorzugte Ausführungsform

Bei einer zweiten bevorzugten Ausführungsform der Erfindung ist das Modul "Belichten - Auswaschen" umfassend eine kontinuierlich arbeitende Transportvorrichtung (T1) genauso aufgebaut wie bei der ersten bevorzugten Ausführungsform. Es wird hierzu auf die oben gemachten Ausführungen verwiesen.

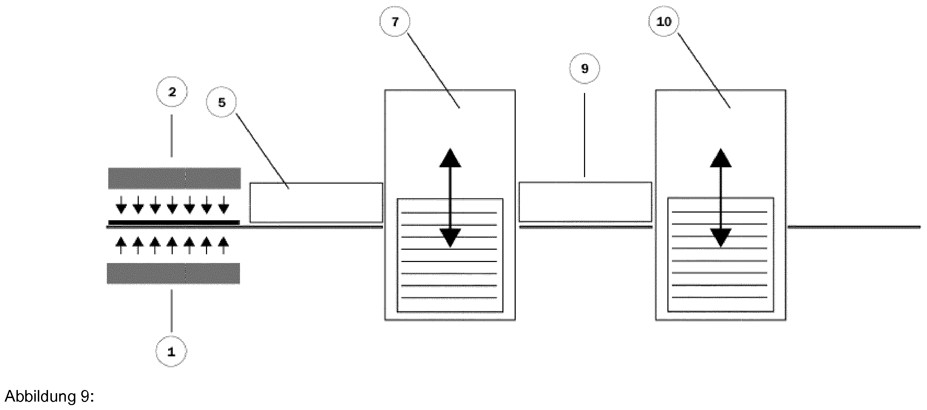

Die Vorrichtung unterscheidet sich aber im Hinblick auf den Aufbau des Moduls "Trocknen - Nachbehandeln" und den Transport der Flexodruckplatten in diesem Modul. Der Aufbau der zweiten bevorzugten Ausführungsform ist schematisch in Abbildung 9 dargestellt. Abbildung 9 zeigt schematisch die Einheiten zur Rückseitenvorbelichtung (1), die Einheit zur Hauptbelichtung (2) sowie die Auswascheinheit (5).

Im Anschluss an die Auswascheinheit (5) sind die Trockeneinheit (7), die Nachbehandlungseinheit (9) sowie eine Speichereinheit (10) hintereinander angeordnet, die Nachbehandlungseinheit (9) ist also zwischen der Trockeneinheit (7) und der Speichereinheit (10) angeordnet.

Bei der zweiten bevorzugten Ausführungsform umfasst die Trockeneinheit (7) mindestens zwei übereinander angeordnete Fächer zur Aufnahme von ausgewaschenen Flexodruckplatten. Bevorzugt handelt es sich um mehrere übereinander angeordnete Fächer, beispielsweise 5 bis 15 Fächer. Die Trockenfächer verfügen jeweils auf beiden Seiten über einen Mechanismus, beispielsweise eine pneumatisch betriebene Klappe zum Verschließen und Öffnen des Trockenfachs. Erfindungsgemäß können die Fächer mittels eines geeigneten Antriebs vertikal innerhalb der Trockeneinheit (7) bewegt werden.

Auch die Speichereinheit (10) umfasst mindestens zwei übereinander angeordnete Fächer zur Aufnahme von fertigen Flexodruckplatten. Bevorzugt handelt es sich um mehrere übereinander angeordnete Fächer, beispielsweise 5 bis 15 Fächer. Erfindungsgemäß können die Fächer mittels eines geeigneten Antriebs vertikal innerhalb der Speichereinheit (10) bewegt werden.

Zum Transport der Flexodruckelemente umfasst die Vorrichtung in der zweiten bevorzugten Ausführungsform eine zweite, diskontinuierlich arbeitende Transportvorrichtung (T3), umfassend mindestens eine in der Nachbehandlungseinheit (9) fixierte Greifvorrichtung (25), mit welchem die Flexodruckplatten an der Transportleiste (14) gegriffen werden können.

Mittels des beschriebenen Greifvorrichtung können die Flexodruckelemente am Auslauf der Auswascheinheit (5) der Transportvorrichtung (T1) entnommen werden und horizontal in den Trockner (7), die Nachbehandlungseinheit (9) sowie die Speichereinheit (10) verschoben werden. Bei der Greifvorrichtung (25) kann es sich beispielsweise um einen verschiebbaren Rahmen handeln, der an beiden Enden Greif- oder Klemmvorrichtungen aufweist, die die Transportleiste umschließen und ziehen können.

Beim Transport mittels der Transportvorrichtung (T3) bleibt das Flexodruckelement auf einer Ebene. Zum Trocknen in der Trockeneinheit (7) werden die Trockenfächer des Trockners mittels der vertikalen Verstellmöglichkeit -sofern erforderlichzunächst so verstellt, dass sich ein leeres Trockenfach auf der Transportebene befindet. Dann greift die Greifvorrichtung durch das geöffnete Trockenfach und zieht das zu trocknende Flexodruckelement an der Transportleiste (14) in das Trockenfach. Nach dem Trocknen müssen die Trockenfächer wieder so eingestellt werden, dass das Fach mit der fertig getrockneten Flexodruckplatte auf der Transportebene liegt, und dann kann das Fach geöffnet und die Flexodruckplatte in die Nachbehandlungseinheit (9) gezogen werden.

Nach der Nachbehandlung werden die Fächer der Speichereinheit (10) so eingestellt, dass ein leeres Speicherfach auf der Transportebene liegt, und danach kann die nachbehandelte Flexodruckplatte mittels der Greifvorrichtung aus der Nachbehandlungseinheit (9) in die Speichereinheit (19) verschoben werden.

### Dritte bevorzugte Ausführungsform

Die dritte bevorzugte Ausführungsform entspricht weitgehend der zweiten bevorzugten Ausführungsform. Es wird auf die obigen Ausführungen verwiesen. Im Unterschied zur zuvor beschriebenen zweiten bevorzugten Ausführungsform verfügt die Vorrichtung neben der kontinuierlich arbeitenden Transportvorrichtung (T1) aber über zwei unabhängig voneinander operierende, jeweils diskontinuierlich arbeitende Transportvorrichtungen (T4) und (T5).

Die diskontinuierlich arbeitende Transportvorrichtung (T4) umfasst mindestens eine im Auslauf der Auswascheinheit (5) fixierte Greifvorrichtung (25), mit welchem die ausgewaschenen Flexodruckplatten an der Transportleiste (14) gegriffen werden können. Mittels der Transportvorrichtung (T4) können die Flexodruckelemente am Auslauf der Auswascheinheit (5) der Transportvorrichtung (T1) entnommen werden und horizontal in den Trockner (7) verschoben werden.
Die diskontinuierlich arbeitende Transportvorrichtung (T5) umfasst mindestens eine in der Nachbehandlungseinheit (9) fixierte Greifvorrichtung (25), mit welchem die Flexodruckplatten an der Transportleiste (14) gegriffen, dem Trockner (7) entnommen und horizontal in die Nachbehandlungseinheit (9) sowie die Speichereinheit (10) verschoben werden können.

Die Funktionsweise der Vorrichtung entspricht im Übrigen der zweiten bevorzugten Ausführungsform. Die Verwendung zweier separat voneinander operierender Transportvorrichtungen (T4) und (T5) bedeutet zwar einen höheren apparativen Aufwand, hat aber den Vorteil, dass die Verarbeitungskapazität der Anlage steigt.

### Modularer Aufbau

In einer Ausführungsform der Erfindung kann die Vorrichtung so konstruiert sein, dass sie aus mindestens zwei Modulen zusammengebaut wird, wobei die Module jeweils auch für sich alleine funktionsfähig sind.
Grundmodul ist hierbei das oben beschriebene Modul "Belichten - Auswaschen", umfassend eine kontinuierlich arbeitende Transportvorrichtung (T1). Dieser kann separat betrieben und die ausgewaschenen Flexodruckplatten können anschließend auf konventionelle Art und Weise getrocknet und nachbehandelt werden.

Das genannte Grundmodul kann von den Betreibern der Anlage mit weiteren Modulen ergänzt werden. Ein ergänzendes Modul ist in einer Ausführungsform das oben beschriebene Modul "Trocknen - Nachbehandeln" mit einer diskontinuierlichen Transportvorrichtung (T2) oder alternativ die bei der zweiten bis vierten bevorzugten Ausführungsform beschriebenen Module "Trocknen - Nachbehandeln".

Es ist auch denkbar, das Modul "Trocknen - Nachbehandeln" in zwei Teilmodule zu zerlegen, und zwar ein Teilmodul "Trocknen" umfassend eine Trockeneinheit (7) sowie eine Transportvorrichtung (T2) sowie ein Teilmodul "Nachbehandeln - Speichern" umfassend eine Nachbehandlungseinheit (9) und eine Speichereinheit (10). Die Kombination aus dem Grundmodul und dem Teilmodul "Trocknen" kann zum Belichten, Auswaschen und Trocknen verwendet werden, und die getrockneten Flexodruckplatten können anschließend manuell einem Nachbelichter zugeführt werden. Durch Kombination mit dem Teilmodul "Nachbehandeln - Speichern" erhält man die vollständige, oben beschriebene Apparatur.

### Erfindungsgemäßes Verfahren

Mittels der beschriebenen Vorrichtung lassen sich kontinuierlich Flexodruckelemente zur Flexodruckplatten verarbeiten.

Für das erfindungsgemäße Verfahren wird als Ausgangsmaterial ein digital bebilderbares Flexodruckelement umfassend mindestens eine UV-transparente, dimensionsstabile Trägerfolie, eine fotopolymerisierbare, reliefbildende Schicht sowie eine digital bebilderbare Schicht eingesetzt und zu einer druckfertigen Flexodruckform verarbeitet.

Bevorzugt wird das beschriebene Flexodruckelement mit einer PET-Folie mit geringem Schrumpf verwendet.
Das Verfahren umfasst in prinzipiell bekannter Art und Weise mindestens die folgenden Verfahrensschritte
(i) Einschreiben einer Maske in die digital bebilderbare Schicht,
(ii) Rückseitenvorbelichtung des bebilderten Flexodruckelements mit UV-Strahlung durch die Trägerfolie hindurch,
(iii) Belichten des bebilderten Flexodruckelements mit UV- Strahlung durch die gebildete Maske hindurch,
(iv) Entfernen der Reste der digital bebilderbaren Schicht sowie der nicht polymerisierten Anteile der reliefbildenden Schicht unter Verwendung von Auswaschmitteln,
(v) Trocknen der erhaltenen Flexodruckform,
(vi) Nachbehandeln der Flexodruckform UVA- und/oder UVC-Licht.

Erfindungsgemäß führt man mindestens die Verfahrensschritte (ii), (iii), (iv), (v) und (vi) unter Verwendung der beschriebenen Vorrichtung durch.

In einer Ausführungsform des Verfahrens setzt man eine Vorrichtung ein, welche zusätzlich eine Einheit zur digitalen Bebilderung, insbesondere eine Einheit zum Einschreiben einer Maske in eine laserablatierbare Schicht umfasst, und man führt auch Verfahrensschritt (i) unter Verwendung der Vorrichtung aus.

In einer bevorzugten Ausführungsform des Verfahrens setzt man eine Vorrichtung gemäß einer der oben geschilderten bevorzugten Ausführungsformen der Vorrichtung ein, besonders bevorzugt eine Vorrichtung gemäß der ersten bevorzugten Ausführungsform.

Da das Auswaschen der belichteten Flexodruckelemente in der Auswascheinheit (5) im Vergleich zur Haupt- und Rückseitenbelichtung der geschwindigkeitsbestimmende Schritt ist, richtet sich die Transportgeschwindigkeit der Transportvorrichtung (T1) nach der notwendigen Auswaschzeit, und zwar wird die Transportgeschwindigkeit so gewählt, dass die Verweildauer des auszuwaschenden Flexodruckelements in der Auswascheinheit (5) mindestens so lange ist, um ein vollständiges Entfernen der nicht polymerisierten Anteile der reliefbildenden Schicht zu gewährleisten. Die Verweildauer darf auch länger sein, sie darf aber nicht kürzer sein als die beschriebene Mindestdauer.

Die Auswaschzeit für ein Flexodruckelement richtet sich im Wesentlichen nach der Dicke des Flexodruckelements, dessen Aufbau und der Art und Temperatur des verwendeten Auswaschmittels. Die Bedingungen werden vom Fachmann entsprechend gewählt. Für kommerziell erhältliche Flexodruckelemente existieren Tabellen mit empfohlenen Auswaschgeschwindigkeiten, ansonsten lassen sich die optimalen Auswaschgeschwindigkeiten vom Fachmann leicht bestimmen.

In der Regel liegt die Transportgeschwindigkeit -abhängig von der Plattendicke- bei 50 mm/min bis 900 mm/min. Der minimale Wert von 50 mm/min kann beim Entwickeln sehr dicker Platten notwendig sein, während dünne Platten u.U. mit bis zu 900 mm/min entwickelt bzw. ausgewaschen werden können.

Sofern unterschiedliche Flexodruckelemente, insbesondere Flexodruckelemente unterschiedlicher Dicke verarbeitet werden, richtet sich die Geschwindigkeit der Transportvorrichtung (T1) nach dem Flexodruckelement mit der längsten Auswaschdauer.

In einer Ausführungsform stellt man die Geschwindigkeit der Transportvorrichtung (T1) mittels der Steuerungseinheit (11) auf einen festen Wert ein und die Leistung und/oder Belichtungszeit der Belichtungseinheit zur Rückseitenvorbelichtung (1) und die Leistung und/oder Belichtungszeit der Belichtungseinheit zur Hauptbelichtung (2) werden entsprechend der Transportgeschwindigkeit und der jeweils zu verarbeitenden Platte eingestellt.

Aufgrund der eingestellten Transportgeschwindigkeit ist die Zeit, die das Flexodruckelement benötigt, um die Module zur Rückseitenvorbelichtung und zur Hauptbelichtung zu passieren, fixiert, und damit ist auch zwangsläufig die jeweils maximal mögliche Belichtungszeit fixiert. Wie gesehen können sich die Transportgeschwindigkeiten um den Faktor 10 unterscheiden, und dementsprechend können auch die maximal möglichen Belichtungszeiten um den Faktor 10 unterschiedlich sein.

Erfindungsgemäß wird mittels der Steuerungseinheit (11) die Leistung der UV-Quellen zur Rückseitenvorbelichtung und zur Hauptbelichtung entsprechend der fixierten Belichtungszeit so angepasst, dass eine zufriedenstellende bildmäßige Vernetzung der reliefbildenden Schicht stattfindet.

Die weitere Verarbeitung der Flexodruckelemente nach dem Auswaschen erfolgt wie bereits oben geschildert.

### Bevorzugte Flexodruckelemente zur Verarbeitung mit der erfindunqsqemäßen Vorrichtung

Zur Verarbeitung mit der erfindungsgemäßen Vorrichtung können prinzipiell alle fotopolymerisierbaren Flexodruckelemente verwendet werden, welche mindestens einen dimensionsstabilen Träger, eine -bevorzugt in organischen Auswaschmitteln auswaschbare- reliefbildende, fotopolymerisierbare Schicht sowie eine digital bebilderbare Schicht umfassen.

Plattenförmige, digital bebilderbare Flexodruckelemente sind dem Fachmann prinzipiell bekannt, und sie sind kommerziell erhältlich. Beispiele derartiger Flexodruckelemente sind beispielsweise in US 5,262,275, EP-A 1 069 475, WO 2008/095994 A1, WO 2009/141256 A1 oder WO 2012/010459 A1 beschrieben. Der Fachmann trifft je nach den gewünschten Eigenschaften der Flexodruckplatte eine geeignete Auswahl.

Zur Verarbeitung in der erfindungsgemäßen Vorrichtung können bevorzugt Flexodruckelemente mit einer Trägerfolie mit einer Dicke von 50 bis 300 µm eingesetzt werden. In aller Regel handelt es sich um eine Trägerfolie aus einem für UV-Licht zumindest teilweise transparenten Material, um die Rückseitenvorbelichtung des Flexodruckelements zu erlauben. Geeignet sind insbesondere PET-Folien.

Die fotopolymerisierbare, reliefbildende Schicht umfasst in prinzipiell bekannter Art und Weise mindestens ein elastomeres Bindemittel, ein ethylenisch ungesättigtes Monomer sowie einen Fotoinitiator oder ein Fotoinitiatorsystem. Neben den genannten Komponenten können optional noch weitere Komponenten wie beispielsweise Weichmacher vorhanden sein. Bevorzugt handelt es sich um eine in organischen Auswaschmitteln lösliche Schicht, aber selbstverständlich können auch Flexodruckelemente mit wasserlöslichen, reliefbildenden Schichten in der erfindungsgemäßen Vorrichtung verarbeitet werden. Bei den elastomeren Bindemitteln kann es sich beispielsweise um thermoplastisch-elastomere Blockcopolymere, beispielsweise Styrol-Butadien- oder Styrol-Isopren-Blockcopolymere handeln. Die reliefbildende Schicht weist in der Regel eine Schichtdicke von 300 µm bis 7000 µm, bevorzugt 1000 µm bis 5000 µm auf. Selbstverständlich können eingesetzte Flexodruckelement auch mehrere fotopolymerisierbare, reliefbildende Schichten verschiedener Zusammensetzung übereinander umfassen.

Bei der digital bebilderbaren Schicht kann es sich beispielsweise um eine laserablatierbare Schicht, um eine mittels Ink-Jet-Drucker beschreibbare Schicht oder um eine thermographische Schicht handeln. Bevorzugt handelt es sich um eine laserablatierbare Schicht.

Die laserablatierbare Maskenschicht, auch LAMS-Schicht genannt, umfasst mindestens ein elastisches Bindemittel, insbesondere ein weichelastisches Bindemittel. Selbstverständlich können auch Gemische mehrerer verschiedener Bindemittel eingesetzt werden. Beispiele geeigneter Bindemittel umfassen weichelastische Polyamide. Derartige Polyamide umfassen als monomere Bausteine langkettige, bifunktionelle Fettsäuren, die dem Polyamid weichelastische Eigenschaften verleihen. Weiterhin können Polyesteramide, Cellulosederivate, Nitrocellulose, Polyvinylalkohole, Polyvinylacetat, Ethylenvinylacetatcopolymere, Polyacrylate oder Mischungen der genannten Polymere eingesetzt werden, sofern sie weichelastische Eigenschaften besitzen.

Die laserablatierbare Maskenschicht umfasst weiterhin UV- absorbierende Materialien. Als UV-absorbierendes Material eignet sich insbesondere feinteiliger Ruß. Ruß absorbiert auch sehr gut im IR-Bereich und gewährleistet somit bei der Bebilderung mittels IR-Laser gleichzeitig auch eine schnelle Bebilderung. Selbstverständlich kann die laserablatierbare Maskenschicht aber auch andere UV- oder IR- Absorber auf Pigmentbasis oder lösliche Farbstoffe enthalten. Ruß ist üblicherweise in einer Menge von 10 bis 50 Gew.-% bezüglich der Summe aller Komponenten enthalten. Die Schichtdicke der Maskenschicht sollte einige wenige µm, bevorzugt 1 µm bis 4 µm betragen.

Zum Schutz der Maskenschicht weist das Flexodruckelement üblicherweise eine Deckfolie auf.

Darüber hinaus kann das Flexodruckelement optional noch weitere Schichten umfassen, wie beispielsweise elastische Unterschichten, Haftschichten oder entklebende Schichten.

Zwischen der fotopolymerisierbaren Schicht und der laserablatierbaren Schicht kann weiterhin optional eine für UVA-Licht transparente Barriereschicht für Sauerstoff angeordnet sein. Eine derartige Schicht limitiert oder verhindert während des Belichtens die Diffusion von Sauerstoff in die fotopolymerisierbare Schicht und trägt somit zu einem besseren Druckbild bei. Die Barriereschicht kann in prinzipiell bekannter Art und Weise ein polymeres Bindemittel mit einer niedrigen Durchlässigkeit für Sauerstoff umfassen. Beispiele geeigneter Bindemittel umfassen Polyamide, Polyvinylalkohol, Hydroxyalkylcellulose, Polyvinylpyrrolidon, Polyvinylacetat, Ethylen-Vinylacetat-Copolymere, amphotere Interpolymere, Celluloseacetatbutyrat, Alkylcellullose, Butyral, cyclische Kautschuke oder Kombinationen davon. Eine Barriereschicht weist üblicherweise eine Schichtdicke von 0.3 µm bis 5 µm auf. Weitere Einzelheiten zu Barriereschichten sind beispielsweise in US 5,262,275 oder WO 2012/145111 A1 offenbart.

## Patentansprüche

1. Vorrichtung zur Herstellung von Flexodruckplatten ausgehend von digital bebilderbaren Flexodruckelementen umfassend mindestens eine dimensionsstabile Trägerfolie, eine fotopolymerisierbare, reliefbildende Schicht sowie eine digital bebilderte Schicht umfassend mindestens
• eine Belichtungseinheit (1) zur Rückseitenvorbelichtung der Flexodruckelemente mittels UV-Strahlung,
• eine Belichtungseinheit (2) zur Hauptbelichtung der Flexodruckelemente mittels UV-Strahlung durch die digital bebilderte Schicht,
• eine Auswascheinheit (5) zum Entfernen der Reste der digital bebilderten Schicht sowie der nicht polymerisierten Anteile der reliefbildenden Schicht unter Verwendung von Auswaschmitteln,
• eine Trockeneinheit (7) zum Trocknen der ausgewaschenen Flexodruckplatten,
• eine Nachbehandlungseinheit (9) zum Nachbehandeln der getrockneten Flexodruckplatten mit UVA- und/oder UVC-Licht,
• eine Speichereinheit (10) zur Aufnahme der fertigen Flexodruckplatten,
• eine Steuerungseinheit (11) zur Steuerung in der Vorrichtung,
**dadurch gekennzeichnet, dass** die Vorrichtung mindestens zwei verschiedene Transportvorrichtungen (T) zum Transport der Flexodruckelemente bzw. Flexodruckplatten durch die Anlage umfasst,
wobei es sich bei einer der Vorrichtungen (T) um eine kontinuierlich arbeitende Transportvorrichtung (T1) handelt, die eingerichtet ist, Flexodruckelemente durch die Belichtungseinheiten (1) und (2) sowie die Auswascheinheit (5) zu transportieren, und wobei
a) die Vorrichtung neben der kontinuierlichen Transporteinheit (T1) eine zweite, diskontinuierlich arbeitende Transportvorrichtung (T2, T3) umfasst, wobei die Flexodruckplatten mit der zweiten diskontinuierlich arbeitenden Transportvorrichtung (T2, T3) in die Trockeneinheit (7) in die Nachbehandlungseinheit (9) sowie die Speichereinheit (10) transportiert werden, oder
b) die Vorrichtung neben der kontinuierlichen Transporteinheit (T1) eine zweite diskontinuierlich arbeitende Transportvorrichtung (T4) und eine dritte, diskontinuierlich arbeitende Transportvorrichtung (T5) umfasst, wobei die Flexodruckplatten mit der zweiten diskontinuierlich arbeitenden Transportvorrichtung (T4) in die Trockeneinheit (7) transportiert werden und mit der dritten diskontinuierlich arbeitenden Transportvorrichtung (T5) in die Nachbehandlungseinheit (9) sowie die Speichereinheit (10) transportiert werden.

2. Vorrichtung gemäß Anspruch 1, **dadurch gekennzeichnet, dass** die Vorrichtung weiterhin eine in Transportrichtung vor der Belichtungs- und Rückseitenvorbelichtungseinheit angeordnete Einheit zur digitalen Bebilderung umfasst.

3. Vorrichtung gemäß Anspruch 1 oder 2, **dadurch gekennzeichnet, dass**
• die Belichtungseinheit (1) unterhalb der Transportvorrichtung (T1) angeordnet ist und mindestens eine in der Leistung regelbare UV-Quelle umfasst,
• die Belichtungseinheit (2) oberhalb der Transportvorrichtung (T1) angeordnet ist und mindestens eine in der Leistung regelbare UV-Quelle umfasst, mit der Maßgabe, dass die Belichtungseinheit (2) in Transportrichtung hinter der Belichtungseinheit (1) angeordnet ist oder dass die Belichtungseinheiten (1) und (2) einander gegenüber liegend angeordnet sind,
• und die Steuerungseinheit (11) eingerichtet ist, mindestens die Transportgeschwindigkeit der Transportvorrichtung (T1), die Leistung und/oder Belichtungszeit der Belichtungseinheit (1) zur Rückseitenvorbelichtung sowie die Leistung und/oder Belichtungszeit der Belichtungseinheit (2) zur Hauptbelichtung zu regeln.

4. Vorrichtung gemäß Anspruch 3, **dadurch gekennzeichnet, dass** die Belichtungseinheit (2) und/oder die Rückseitenvorbelichtungseinheit (1) höhenverstellbar sind.

5. Vorrichtung gemäß einem der Ansprüche 1 bis 4, **dadurch gekennzeichnet, dass** die Auswascheinheit (5) zwei separate Waschzonen umfasst.

6. Vorrichtung gemäß einem der Ansprüche 1 bis 5, **dadurch gekennzeichnet, dass** die Transportvorrichtung (T1) zwei parallel zueinander in Transportrichtung verlaufende Transportelemente (13) umfasst, wobei die Flexodruckelemente mit einer Transportleiste (14) verbunden sind, welche eingerichtet ist, um mit ihren jeweiligen Enden (15) in die Transportelemente (13) eingehängt zu werden.

7. Vorrichtung gemäß einem der Ansprüche 1 bis 6, **dadurch gekennzeichnet, dass** die Vorrichtung weiterhin eine Beladungseinheit (12) umfasst, die eingerichtet ist, die Transportvorrichtung (T1) automatisch mit Flexodruckelementen zu beladen und dass die Beladungseinheit optional eine Stanze umfasst, die eingerichtet ist, die Flexodruckelemente zu stanzen und anschließend die gestanzten Flexodruckelemente mit einer Transportleiste (14) zu verbinden.

8. Vorrichtung gemäß einem der Ansprüche 1 bis 7, **dadurch gekennzeichnet, dass** die Flexodruckplatten mit der zweiten Transportvorrichtung (T2) gemäß Alternative a) in die Trockeneinheit (7), die Nachbehandlungseinheit (9) sowie die Speichereinheit (10) transportiert werden, wobei die Flexodruckplatten in einer Übergabeeinheit (6) von der kontinuierlichen Transportvorrichtung (T1) an die zweite Transportvorrichtung (T2) übergeben werden.

9. Vorrichtung gemäß Anspruch 8, **dadurch gekennzeichnet dass** die zweite Transportvorrichtung (T2) eingerichtet ist, eine bewegliche Unterlage (17) für Flexodruckplatten aufzunehmen, wobei die bewegliche Unterlage mittels einer geeigneten Konstruktion horizontal und vertikal verschiebbar ist, so dass die beweglichen Unterlagen (17) jeweils aus der Transportvorrichtung (T2) in die Übergabeeinheit (6), den Trockner (7), die Nachbehandlungseinheit (9) sowie die Speichereinheit (10) verschoben werden und/oder den genannten Einheiten wieder entnommen werden können.

10. Vorrichtung gemäß Anspruch 9, **dadurch gekennzeichnet, dass** die Transportvorrichtung (T2) eine Verschiebevorrichtung (18) umfassend eine automatisch gesteuerte Ankupplungsvorrichtung (23) umfasst, welche zum Verschieben reversibel mit entsprechenden Kupplungen (19) auf der Unterseite der beweglichen Unterlage (17) verbunden werden kann.

11. Vorrichtung gemäß Anspruch 9 oder 10, **dadurch gekennzeichnet, dass** die Trockeneinheit (7) mehrere übereinander angeordnete Fächer zur Aufnahme von Flexodruckplatten umfasst, wobei die Fächer der Trockeneinheit (7) jeweils über eigene Heizelemente und eine eigene Regelung verfügen.

12. Vorrichtung gemäß einem der Ansprüche 9 bis 11, **dadurch gekennzeichnet, dass** die Vorrichtung aus mindestens zwei voneinander trennbaren Modulen aufgebaut ist, welche jeweils auch für einen separaten Betrieb eingerichtet sind und dass die Vorrichtung einen Grundmodul "Belichten - Auswaschen" umfasst, umfassend
• eine Belichtungseinheit (1) zur Rückseitenvorbelichtung der Flexodruckelemente mittels UV-Strahlung,
• eine Belichtungseinheit (2) zur Hauptbelichtung der Flexodruckelemente mittels UV-Strahlung durch die digital bebilderte Schicht, sowie
• eine Auswascheinheit (5) zum Entfernen der Reste der digital bebilderten Schicht sowie der nicht polymerisierten Anteile der reliefbildenden Schicht unter Verwendung von Auswaschmitteln, und
• eine kontinuierlich arbeitende Transportvorrichtung (T1), mit der die Flexodruckelemente durch die Belichtungseinheiten (1) und (2) sowie die Auswascheinheit (3) transportiert werden.

13. Vorrichtung gemäß Anspruch 12, **dadurch gekennzeichnet, dass** die Vorrichtung ein Modul "Trocknen - Nachbehandeln" umfasst, umfassend
• eine Trockeneinheit (7),
• eine Nachbehandlungseinheit (9)
• eine Speichereinheit (10),
• ein diskontinuierlich arbeitende Transportvorrichtung (T2), und
• eine Übergabeeinheit (6), in der ausgewaschene Flexodruckplatten von der Transportvorrichtung (T1) an die Transportvorrichtung (T2) übergeben werden.

14. Vorrichtung gemäß einem der Ansprüche 1 bis 7, **dadurch gekennzeichnet, dass**
• die Trockeneinheit (7) mindestens zwei übereinander angeordnete Fächer zur Aufnahme von Flexodruckplatten umfasst, wobei die Fächer mittels eines geeigneten Antriebs vertikal innerhalb der Trockeneinheit (7) bewegt werden können,
• die Speichereinheit (10) mindestens zwei übereinander angeordnete Fächer zur Aufnahme von Flexodruckplatten umfasst, wobei die Fächer mittels eines geeigneten Antriebs vertikal innerhalb der Speichereinheit (10) bewegt werden können,
• die Nachbehandlungseinheit (9) zwischen der Trockeneinheit (7) und der Speichereinheit angeordnet ist, und
• die zweite, diskontinuierlich arbeitende Transportvorrichtung (T3) gemäß Alternative a) mindestens eine in der Nachbehandlungseinheit (9) fixierte Greifvorrichtung (25) umfasst, mit welcher die Flexodruckplatten an der Transportleiste (14) gegriffen werden können, am Auslauf der Auswascheinheit (5) der Transportvorrichtung (T1) entnommen werden und horizontal in den Trockner (7), die Nachbehandlungseinheit (9) sowie die Speichereinheit (10) verschoben werden können.

15. Vorrichtung gemäß einem der Ansprüche 1 bis 7, **dadurch gekennzeichnet, dass**
• die Trockeneinheit (7) mindestens zwei übereinander angeordnete Fächer zur Aufnahme von Flexodruckplatten umfasst, wobei die Fächer mittels eines geeigneten Antriebs vertikal innerhalb der Trockeneinheit (7) bewegt werden können,
• die Speichereinheit (10) mindestens zwei übereinander angeordnete Fächer zur Aufnahme von Flexodruckplatten umfasst, wobei die Fächer mittels eines geeigneten Antriebs vertikal innerhalb der Speichereinheit (10) bewegt werden können,
• die Nachbehandlungseinheit (9) zwischen der Trockeneinheit (7) und der Speichereinheit angeordnet ist,
• die zweite, diskontinuierlich arbeitende Transportvorrichtung (T4) gemäß Alternative b) mindestens eine im Auslauf der Auswascheinheit (5) fixierte Greifvorrichtung (25) umfasst, mit welcher die Flexodruckplatten an der Transportleiste (14) gegriffen werden können und am Auslauf der Auswascheinheit (5) der Transportvorrichtung (T1) entnommen werden und horizontal in den Trockner (7) verschoben werden können, und
• die Vorrichtung die dritte, diskontinuierlich arbeitende Transportvorrichtung (T5) gemäß Alternative b) umfasst, umfassend mindestens einen in der Nachbehandlungseinheit (9) fixierten Greifvorrichtung (25), mit welchem die Flexodruckplatten an der Transportleiste (14) gegriffen, dem Trockner (7) entnommen und horizontal in die Nachbehandlungseinheit (9) sowie die Speichereinheit (10) verschoben werden können.

16. Verfahren zur Herstellung von Flexodruckplatten ausgehend von digital bebilderbaren Flexodruckelementen umfassend mindestens eine dimensionsstabile Trägerfolie, eine fotopolymerisierbare, reliefbildende Schicht sowie eine digital bebilderbare Schicht umfassend mindestens die folgenden Verfahrensschritte:
(i) Einschreiben einer Maske in die digital bebilderbare Schicht,
(ii) Rückseitenvorbelichtung des bebilderten Flexodruckelements mit UV-Strahlung durch die Trägerfolie hindurch,
(iii) Belichten des bebilderten Flexodruckelements mit UV- Strahlung durch die gebildete Maske hindurch,
(iv) Entfernen der Reste der digital bebilderbaren Schicht sowie der nicht polymerisierten Anteile der reliefbildenden Schicht unter Verwendung von Auswaschmitteln,
(v) Trocknen der erhaltenen Flexodruckform,
(vi) Nachbehandeln der Flexodruckform UVA- und/oder UVC-Licht,
**dadurch gekennzeichnet, dass** man mindestens die Verfahrensschritte (ii), (iii), (iv), (v) und (vi) unter Verwendung einer Vorrichtung gemäß einem der Ansprüche 1 bis 15 durchführt.

17. Verfahren gemäß Anspruch 16, **dadurch gekennzeichnet, dass** die Auswascheinheit (5) zwei separate Waschzonen umfasst, welche mit unterschiedlichen Auswaschmitteln betrieben werden.

18. Verfahren gemäß Anspruch 16 oder 17, **dadurch gekennzeichnet, dass** die Fächer der Trockeneinheit (7) jeweils über eigene Heizelemente und eine eigene Regelung verfügen und die Trockenfächer unabhängig voneinander betrieben werden.

## Claims

1. A device for producing flexographic printing plates starting from digitally imagable flexographic printing elements comprising at least one dimensionally stable support sheet, a photopolymerizable, relief-forming layer, and a digitally imaged layer, comprising at least
• an exposure unit (1) for the preliminary exposure of the flexographic printing elements from the reverse by means of UV radiation,
• an exposure unit (2) for the main exposure of the flexographic printing elements by means of UV radiation through the digitally imaged layer,
• a washout unit (5) for removing the residues of the digitally imaged layer and also the unpolymerized fractions of the relief-forming layer, using washout media,
• a drying unit (7) for drying the washed out flexographic printing plates,
• an aftertreatment unit (9) for aftertreating the dried flexographic printing plates with UVA and/or UVC light,
• a storage unit (10) for accommodating the completed flexographic printing plates,
• a control unit (11) for control in the device,
**characterized in that** the device comprises at least two different transport devices (T) for transporting the flexographic printing elements and flexographic printing plates, respectively, through the system,
where one of the devices (T) is a continuously operating transport device (T1) set up so as to transport flexographic printing elements through the exposure units (1) and (2) and also the washout unit (5), and where
a) the device comprises, as well as the continuous transport unit (T1), a second, discontinuously operating transport device (T2, T3), the flexographic printing plates being transported by the second, discontinuously operating transport device (T2, T3) into the drying unit (7), into the aftertreatment unit (9), and also the storage unit (10), or
b) the device comprises, as well as the continuous transport unit (T1), a second, discontinuously operating transport device (T4) and a third, discontinuously operating transport device (T5), the flexographic printing plates being transported by the second, discontinuously operating transport device (T4) into the drying unit (7) and by the third, discontinuously operating transport device (T5) into the aftertreatment unit (9) and also the storage unit (10).

2. The device as claimed in claim 1, **characterized in that** the device further comprises a digital imaging unit disposed ahead of the exposure and preliminary reverse exposure unit in transport direction.

3. The device as claimed in claim 1 or 2, **characterized in that**
• the exposure unit (1) is disposed below the transport device (T1) and comprises at least one UV source regulatable in its power,
• the exposure unit (2) is disposed above the transport device (T1) and comprises at least one UV source regulatable in its power, with the proviso that the exposure unit (2) is disposed after the exposure unit (1) in transport direction or that the exposure units (1) and (2) are disposed opposite one another,
• and the control unit (11) is set up so as to regulate at least the transport speed of the transport device (T1), the power and/or exposure time of the exposure unit (1) for preliminary reverse exposure, and the power and/or exposure time of the exposure unit (2) for main exposure.

4. The device as claimed in claim 3, **characterized in that** the exposure unit (2) and/or the preliminary reverse exposure unit (1) are height-adjustable.

5. The device as claimed in any of claims 1 to 4, **characterized in that** the washout unit (5) comprises two separate washing zones.

6. The device as claimed in any of claims 1 to 5, **characterized in that** the transport device (T1) comprises two transport elements (13) extending parallel to one another in transport direction, the flexographic printing elements being connected to a transport strip (14), which is set up to be hung by its respective ends (15) into the transport elements (13).

7. The device as claimed in any of claims 1 to 6, **characterized in that** the device further comprises a loading unit (12) which is set up so as to load the transport device (T1) automatically with flexographic printing elements and **in that** the loading unit optionally comprises a punch which is set up to punch the flexographic printing elements and subsequently to connect the punched flexographic printing elements to a transport strip (14).

8. The device as claimed in any of claims 1 to 7, **characterized in that** the flexographic printing plates are transported by the second transport device (T2) as per alternative a) into the drying unit (7), the aftertreatment unit (9), and also the storage unit (10), the flexographic printing plates being transferred from the continuous transport device (T1) onto the second transport device (T2) in a transfer unit (6).

9. The device as claimed in claim 8, **characterized in that** the second transport device (T2) is set up to accommodate a movable underlayer (17) for flexographic printing plates, the movable underlayer being displaceable horizontally and vertically by means of an appropriate construction, thus allowing the movable underlayers (17) to be displaced in each case from the transport device (T2) into the transfer unit (6), the dryer (7), the aftertreatment unit (9), and the storage unit (10), and/or to be retrieved from said units.

10. The device as claimed in claim 9, **characterized in that** the transport device (T2) comprises a displacement device (18) comprising an automatically controlled coupling device (23) which for displacement can be connected reversibly to corresponding couplings (19) on the underside of the movable underlayer (17).

11. The device as claimed in claim 9 or 10, **characterized in that** the drying unit (7) comprises a plurality of drying compartments which are disposed one above another, wherein the compartments of the drying unit (7) each possess their own heating elements and their own regulation.

12. The device as claimed in any of claims 9 to 11, **characterized in that** the device is constructed of at least two modules which can be separated from one another and which are each also set up for separate operation, and **in that** the device comprises a base "exposure - washout" module, comprising
• an exposure unit (1) for the preliminary exposure of the flexographic printing elements from the reverse by means of UV radiation,
• an exposure unit (2) for the main exposure of the flexographic printing elements by means of UV radiation through the digitally imaged layer, and also
• a washout unit (5) for removing the residues of the digitally imaged layer and also the unpolymerized fractions of the relief-forming layer, using washout media, and
• a continuously operating transport device (T1) with which the flexographic printing elements are transported through the exposure units (1) and (2) and also the washout unit (3).

13. The device as claimed in claim 12, **characterized in that** the device comprises a "drying - aftertreatment" module, comprising
• a drying unit (7),
• an aftertreatment unit (9),
• a storage unit (10),
• a discontinuously operating transport device (T2), and
• a transfer unit (6) in which washed out flexographic printing plates are transferred from the transport device (T1) onto the transport device (T2).

14. The device as claimed in any of claims 1 to 7, **characterized in that**
• the drying unit (7) comprises at least two compartments disposed one above another for accommodating flexographic printing plates, the compartments being movable vertically within the drying unit (7) by means of a suitable drive,
• the storage unit (10) comprises at least two compartments disposed one above another for accommodating flexographic printing plates, the compartments being movable vertically within the storage unit (10) by means of a suitable drive,
• the aftertreatment unit (9) is disposed between the drying unit (7) and the storage unit, and
• the second, discontinuously operating transport device (T3) as per alternative a) comprises at least one gripping device (25) which is fixed in the aftertreatment unit (9) and with which the flexographic printing plates on the transport strip (14) can be gripped, taken from the transport device (T1) at the outlet of the washout unit (5), and displaced horizontally into the dryer (7), the aftertreatment unit (9), and also the storage unit (10).

15. The device as claimed in any of claims 1 to 7, **characterized in that**
• the drying unit (7) comprises at least two compartments disposed one above another for accommodating flexographic printing plates, the compartments being movable vertically within the drying unit (7) by means of a suitable drive,
• the storage unit (10) comprises at least two compartments disposed one above another for accommodating flexographic printing plates, the compartments being movable vertically within the storage unit (10) by means of a suitable drive,
• the aftertreatment unit (9) is disposed between the drying unit (7) and the storage unit,
• the second, discontinuously operating transport device (T4) as per alternative b) comprises at least one gripping device (25), which is fixed in the outlet of the washout unit (5) and with which the flexographic printing plates on the transport strip (14) can be gripped, taken from the transport device (T1) at the outlet of the washout unit (5), and displaced horizontally into the dryer (7), and
• the device comprises the third, discontinuously operating transport device (T5) as per alternative b), comprising at least one gripping device (25), which is fixed in the aftertreatment unit (9) and with which the flexographic printing plates can be gripped on the transport strip (14), taken from the dryer (7), and displaced horizontally into the aftertreatment unit (9), and also the storage unit (10).

16. A method for producing flexographic printing plates starting from digitally imagable flexographic printing elements comprising at least one dimensionally stable support sheet, a photopolymerizable, relief-forming layer, and a digitally imagable layer, comprising at least the following method steps:
(i) writing a mask into the digitally imagable layer,
(ii) carrying out preliminary reverse exposure of the imaged flexographic printing element with UV radiation through the support sheet,
(iii) exposing the imaged flexographic printing element with UV radiation through the mask formed,
(iv) removing the residues of the digitally imagable layer and also the unpolymerized fractions of the relief-forming layer, using washout media,
(v) drying the resultant flexographic printing plate,
(vi) (vi) aftertreating the flexographic printing plate UVA and/or UVC light,
**characterized in that** at least method steps (ii), (iii), (iv), (v) and (vi) are carried out using a device as claimed in any of claims 1 to 15.

17. The method as claimed in claim 16, **characterized in that** the washout unit (5) comprises two separate washing zones, which can be operated with different washout media.

18. The method as claimed in claim 16 or 17, **characterized in that** the compartments of the drying unit (7) each possess their own heating elements and their own regulation, and the drying compartments are operated independently of one another.

## Revendications

1. Dispositif de fabrication de plaques de flexographie à partir d'éléments de flexographie pouvant recevoir numériquement une image comprenant au moins un film porteur à stabilité dimensionnelle, une couche photopolymérisable formant un relief ainsi qu'une couche recevant numériquement une image, comprenant au moins
* une unité d'insolation (1) destinée à la préinsolation du côté arrière des éléments de flexographie au moyen d'un rayonnement UV,
* une unité d'insolation (2) destinée à l'insolation principale des éléments de flexographie au moyen d'un rayonnement UV à travers la couche recevant numériquement une image,
* une unité de lessivage (5) destinée à éliminer les résidus de la couche recevant numériquement une image ainsi que les parts non polymérisées de la couche formant un relief en utilisant des agents de lessivage,
* une unité de séchage (7) destinée à sécher les plaques de flexographie lessivées,
* une unité de post-traitement (9) destinée à post-traiter les plaques de flexographie séchées avec de la lumière UVA et/ou UVC,
* une unité de stockage (10) destinée à accueillir les plaques de flexographie terminées,
* une unité de commande (11) destinée à la commande dans le dispositif,
**caractérisé en ce que** le dispositif comporte au moins deux dispositifs de transport (T) différents pour le transport des éléments de flexographie ou des plaques de flexographie à travers l'installation,
l'un des dispositifs (T) étant un dispositif de transport à fonctionnement continu (T1) qui est conçu pour transporter les éléments de flexographie à travers les unités d'insolation (1) et (2) ainsi que l'unité de lessivage (5), et
a) le dispositif comportant, outre l'unité de transport continu (T1), un deuxième dispositif de transport à fonctionnement discontinu (T2, T3), les plaques de flexographie étant transportées avec le deuxième dispositif de transport à fonctionnement discontinu (T2, T3) dans l'unité de séchage (7), dans l'unité de post-traitement (9) ainsi que dans l'unité de stockage (10), ou
b) le dispositif comportant, outre l'unité de transport continu (T1), un deuxième dispositif de transport à fonctionnement discontinu (T4) et un troisième dispositif de transport à fonctionnement discontinu (T5), les plaques de flexographie étant transportées avec le deuxième dispositif de transport à fonctionnement discontinu (T4) dans l'unité de séchage (7) et avec le troisième dispositif de transport à fonctionnement discontinu (T5) dans l'unité de post-traitement (9) ainsi que dans l'unité de stockage (10).

2. Dispositif selon la revendication 1, **caractérisé en ce que** le dispositif comporte en plus une unité servant à la formation numérique d'images disposée avant l'unité d'insolation et de préinsolation du côté arrière dans le sens du transport.

3. Dispositif selon la revendication 1 ou 2, **caractérisé en ce que**
* l'unité d'insolation (1) est disposée au-dessous du dispositif de transport (T1) et comprend au moins une source d'UV dont la puissance est réglable,
* l'unité d'insolation (2) est disposée au-dessus du dispositif de transport (T1) et comprend au moins une source d'UV dont la puissance est réglable, avec pour spécification que l'unité d'insolation (2) est disposée derrière l'unité d'insolation (1) dans le sens du transport ou que les unités d'insolation (1) et (2) sont disposées en vis-à-vis l'une de l'autre,
* et l'unité de commande (11) est conçue pour réguler au moins la vitesse de transport du dispositif de transport (T1), la puissance et/ou le temps d'insolation de l'unité d'insolation (1) destinée à la préinsolation du côté arrière ainsi que la puissance et/ou le temps d'insolation de l'unité d'insolation (2) destinée à l'insolation principale.

4. Dispositif selon la revendication 3, **caractérisé en ce que** l'unité d'insolation (2) et/ou l'unité de préinsolation du côté arrière (1) sont positionnables en hauteur.

5. Dispositif selon l'une des revendications 1 à 4, **caractérisé en ce que** l'unité de lessivage (5) comporte deux zones de lavage séparées.

6. Dispositif selon l'une des revendications 1 à 5, **caractérisé en ce que** le dispositif de transport (T1) comporte deux éléments de transport (13) qui suivent un tracé parallèle l'un à l'autre dans le sens du transport, les éléments de flexographie étant reliés à une baguette de transport (14) qui est conçue pour être accrochée par ses extrémités (15) respectives dans les éléments de transport (13).

7. Dispositif selon l'une des revendications 1 à 6, **caractérisé en ce que** le dispositif comporte en outre une unité de chargement (12) qui est conçue pour charger automatiquement le dispositif de transport (T1) avec des éléments de flexographie et **en ce que** l'unité de chargement comporte en option une perforatrice qui est conçue pour perforer les éléments de flexographie et ensuite relier les éléments de flexographie perforés avec une baguette de transport (14).

8. Dispositif selon l'une des revendications 1 à 7, **caractérisé en ce que** les plaques de flexographie sont transportées avec le deuxième dispositif de transport (T2) selon la variante a) dans l'unité de séchage (7), l'unité de post-traitement (9) ainsi que l'unité de stockage (10), les plaques de flexographie étant transférées du premier dispositif de transport continu (T1) au deuxième dispositif de transport (T2) dans une unité de transfert (6).

9. Dispositif selon la revendication 8, **caractérisé en ce que** le deuxième dispositif de transport (T2) est conçu pour recevoir un substrat mobile (17) pour les plaques de flexographie, le substrat mobile pouvant être déplacé horizontalement et verticalement au moyen d'une construction appropriée, de sorte que les substrats mobiles (17) sont respectivement déplacés hors du dispositif de transport (T2) dans l'unité de transfert (6), le séchoir (7), l'unité de post-traitement (9) ainsi que l'unité de stockage (10) et/ou peuvent de nouveau être retirés desdites unités.

10. Dispositif selon la revendication 9, **caractérisé en ce que** le dispositif de transport (T2) comporte un dispositif de déplacement (18) comprenant un dispositif d'accouplement (23) à commande automatique qui, en vue du déplacement, peut être relié de manière réversible à des coupleurs (19) correspondants sur le côté inférieur du substrat mobile (17).

11. Dispositif selon la revendication 9 ou 10, **caractérisé en ce que** l'unité de séchage (7) comporte plusieurs casiers disposés les uns au-dessus des autres pour accueillir des plaques de flexographie, les casiers de l'unité de séchage (7) disposant respectivement d'éléments chauffants propres et d'une régulation propre.

12. Dispositif selon l'une des revendications 9 à 11, **caractérisé en ce que** le dispositif est constitué d'au moins deux modules pouvant être séparés l'un de l'autre, lesquels sont respectivement aussi conçus pour un fonctionnement séparé et **en ce que** le dispositif comporte un module de base « insolation - lessivage », comprenant
* une unité d'insolation (1) destinée à la préinsolation du côté arrière des éléments de flexographie au moyen d'un rayonnement UV,
* une unité d'insolation (2) destinée à l'insolation principale des éléments de flexographie au moyen d'un rayonnement UV à travers la couche recevant numériquement une image,
* une unité de lessivage (5) destinée à éliminer les résidus de la couche recevant numériquement une image ainsi que les parts non polymérisées de la couche formant un relief en utilisant des agents de lessivage, et
* un dispositif de transport à fonctionnement continu (T1) avec lequel les éléments de flexographie sont transportés à travers les unités d'insolation (1) et (2) ainsi que l'unité de lessivage (5).

13. Dispositif selon la revendication 12, **caractérisé en ce que** le dispositif comporte un module « séchage - post-traitement », comprenant
* une unité de séchage (7),
* une unité de post-traitement (9),
* une unité de stockage (10),
* un dispositif de transport à fonctionnement discontinu (T2), et
* une unité de transfert (6) dans laquelle les plaques de flexographie lessivées sont transférées du dispositif de transport (T1) au dispositif de transport (T2).

14. Dispositif selon l'une des revendications 1 à 7, **caractérisé en ce que**
* l'unité de séchage (7) comporte au moins deux casiers disposés les uns au-dessus des autres pour accueillir des plaques de flexographie, les casiers pouvant être déplacés verticalement à l'intérieur de l'unité de séchage (7) au moyen d'un mécanisme d'entraînement approprié,
* l'unité de stockage (10) comporte au moins deux casiers disposés les uns au-dessus des autres pour accueillir des plaques de flexographie, les casiers pouvant être déplacés verticalement à l'intérieur de l'unité de stockage (10) au moyen d'un mécanisme d'entraînement approprié,
* l'unité de post-traitement (9) est disposée entre l'unité de séchage (7) et l'unité de stockage, et
* le deuxième dispositif de transport à fonctionnement discontinu (T3) selon la variante a) comporte au moins un dispositif de préhension (25) en position fixe dans l'unité de post-traitement (9), avec lequel les plaques de flexographie peuvent être saisies au niveau de la baguette de transport (14), être prélevées du dispositif de transport (T1) à la sortie de l'unité de lessivage (5) et déplacées horizontalement dans le séchoir (7), l'unité de post-traitement (9) ainsi que l'unité de stockage (10).

15. Dispositif selon l'une des revendications 1 à 7, **caractérisé en ce que**
* l'unité de séchage (7) comporte au moins deux casiers disposés les uns au-dessus des autres pour accueillir des plaques de flexographie, les casiers pouvant être déplacés verticalement à l'intérieur de l'unité de séchage (7) au moyen d'un mécanisme d'entraînement approprié,
* l'unité de stockage (10) comporte au moins deux casiers disposés les uns au-dessus des autres pour accueillir des plaques de flexographie, les casiers pouvant être déplacés verticalement à l'intérieur de l'unité de stockage (10) au moyen d'un mécanisme d'entraînement approprié,
* l'unité de post-traitement (9) est disposée entre l'unité de séchage (7) et l'unité de stockage, et
* le deuxième dispositif de transport à fonctionnement discontinu (T4) selon la variante b) comporte au moins un dispositif de préhension (25) en position fixe dans la sortie de l'unité de lessivage (5), avec lequel les plaques de flexographie peuvent être saisies au niveau de la baguette de transport (14) et être prélevées du dispositif de transport (T1) à la sortie de l'unité de lessivage (5) et déplacées horizontalement dans le séchoir (7), et
* le dispositif comporte le troisième dispositif de transport à fonctionnement discontinu (T5) selon la variante b), comprenant au moins un dispositif de préhension (25) en position fixe dans l'unité de post-traitement (9), avec lequel les plaques de flexographie peuvent être saisies au niveau de la baguette de transport (14) et être prélevées du séchoir (7) et déplacées horizontalement dans l'unité de post-traitement (9) ainsi que l'unité de stockage (10).

16. Procédé de fabrication de plaques de flexographie à partir d'éléments de flexographie pouvant recevoir numériquement une image comprenant au moins un film porteur à stabilité dimensionnelle, une couche photopolymérisable formant un relief ainsi qu'une couche pouvant recevoir numériquement une image, comprenant au moins les étapes suivantes :
(i) inscription d'un masque dans la couche pouvant recevoir numériquement une image,
(ii) préinsolation du côté arrière des éléments de flexographie recevant une image avec un rayonnement UV à travers le film porteur,
(iii) insolation des éléments de flexographie recevant une image au moyen d'un rayonnement UV à travers le masque recevant une image,
(iv) élimination des résidus de la couche pouvant recevoir numériquement une image ainsi que des parts non polymérisées de la couche formant un relief en utilisant des agents de lessivage,
(v) séchage du cliché de flexographie obtenu,
(vi) post-traitement du cliché de flexographie avec de la lumière UVA et/ou UVC,
**caractérisé en ce qu'**au moins les étapes (ii), (iii), (iv), (v) et (vi) sont exécutées en utilisant un dispositif selon l'une des revendications 1 à 15.

17. Procédé selon la revendication 16, **caractérisé en ce que** l'unité de lessivage (5) comporte deux zones de lavage séparées qui peuvent fonctionner avec des agents de lessivage différents.

18. Procédé selon la revendication 16 ou 17, **caractérisé en ce que** les casiers de l'unité de séchage (7) disposent respectivement d'éléments chauffants propres et d'une régulation propre et les casiers de séchage peuvent fonctionner indépendamment les uns des autres.
